# EUROPÄISCHE PATENTSCHRIFT

(11) **EP 3 281 223 B1**
(45) Veröffentlichungstag und Bekanntmachung des Hinweises auf die Patenterteilung: **09.09.2020**
(21) Anmeldenummer: 15731568.0
(22) Anmeldetag: 23.06.2015
(51) Int. Cl.: B81C 1/00, B23K 26/00, B28D 1/22

(54) **VERFAHREN ZUM VERLUSTARMEN HERSTELLEN VON MEHRKOMPONENTENWAFERN**
METHOD FOR THE LOW-LOSS PRODUCTION OF MULTI-COMPONENT WAFERS
PROCÉDÉ DE FABRICATION À FAIBLES PERTES DE PLAQUETTES À PLUSIEURS COMPOSANTS

(30) Priorität: 09.04.2015 DE 102015004601; 01.06.2015 DE 102015006971
(43) Veröffentlichungstag der Anmeldung: 14.02.2018
(73) Patentinhaber: Siltectra GmbH, 01099 Dresden (DE)
(72) Erfinder: DRESCHER, Wolfram, 01099 Dresden (DE); SCHILLING, Franz, 01454 Radeberg (DE); RICHTER, Jan, 01277 Dresden (DE)
(74) Vertreter: Westphal, Mussgnug & Partner Patentanwälte mbB
(86) Internationale Anmeldenummer: PCT/EP2015/064104
(87) Internationale Veröffentlichungsnummer: WO 2016/162096

(56) Entgegenhaltungen:
- WO-A2-2009/061353
- US-A1- 2014 038 392

## Beschreibung

Die vorliegende Erfindung bezieht sich auf ein Verfahren zur Herstellung eines Mehrkomponentenwafers, insbesondere eines MEMS-Wafers, und auf eine Verwendung eines Substrats als Spenderwafer und Bondwafer in einem Mehrkomponentenwaferherstellungsverfahren, insbesondere einem MEMS-Waferherstellungsverfahren.

In vielen technischen Bereichen (z.B. Mikroelektronik- oder Photovoltaiktechnologie) werden Materialien, wie z.B. Silizium, Germanium oder Saphir, häufig in der Form dünner Scheiben und Platten (so genannte Wafer) gebraucht. Standardmäßig werden solche Wafer derzeit durch Sägen aus einem Ingot hergestellt, wobei relativ große Materialverluste ("kerf-loss") entstehen. Da das verwendete Ausgangsmaterial oft sehr teuer ist, gibt es starke Bestrebungen, solche Wafers mit weniger Materialaufwand und damit effizienter und kostengünstiger herzustellen.

Beispielsweise gehen mit den derzeit üblichen Verfahren allein bei der Herstellung von Siliziumwafern für Solarzellen fast 50% des eingesetzten Materials als "kerf-loss" verloren. Weltweit gesehen entspricht dies einem jährlichen Verlust von über 2 Milliarden Euro. Da die Kosten des Wafers den größten Anteil an den Kosten der fertigen Solarzelle ausmachen (über 40%), könnten durch entsprechende Verbesserungen der Waferherstellung die Kosten von Solarzellen signifikant reduziert werden.

Besonders attraktiv für eine solche Waferherstellung ohne kerf-loss ("kerf-free wafering") erscheinen Verfahren, wie sie z.B. in der US 2014 038392 A1_beschrieben sind, die auf das herkömmliche Sägen verzichten und z.B. durch Einsatz von temperaturinduzierten Spannungen direkt dünne Wafer von einem dickeren Werkstück abspalten können. Dazu gehören insbesondere Verfahren, wie sie z.B. in WO 2009/061353 A2 und WO 2010/072675 A2 beschrieben sind, wo zum Erzeugen dieser Spannungen eine auf das Werkstück aufgetragene Polymerschicht verwendet wird. US 2014/038392 A1 beschreibt bereits ein Verfahren in dessen Verlauf Laser-Modifikationen zum Trennen einen Wafers ausgenutzt werden und der so abgetrennte Rest des Spenderwafers wiederverwendet wird. Im Einzelnen offenbart dieses Dokument ein Verfahren zur Herstellung eines mehrkomponentigen MEMS-Wafers umfassend die Schritte: Bereitstellen eines Bondwafers, Bereitstellen eines Spenderwafers, in Kontakt bringen des Spenderwafers mit dem durch eine Oxidschicht gebildeten Oberflächenanteil eines Wafers, Bilden einer Mehrschichtanordnung durch Verbinden des Spenderwafers und des Bondwafers im Bereich des Kontakts, Erzeugen von Modifikationen im Inneren des Spenderwafers zum Vorgeben eines Ablösebereichs zum Trennen des Spenderwafers in einen Abtrennteil und einen Verbindungsteil mittels einem LASER-Strahl, Trennen der Mehrschichtanordnung entlang dem Ablösebereich infolge einer durch die Erzeugung einer ausreichenden Anzahl an Modifikationen bewirkten Schwächung der Mehrschichtanordnung, wobei der Verbindungsteil am Bondwafer verbleibt und wobei der abgespaltete Abtrennteil eine größere Dicke aufweist als der Verbindungsteil. Weiterhin wird der Abtrennteil durch eine Behandlung zumindest eines Oberflächenanteils des Abtrennteils in einen weiteren Bondwafer umgewandelt und er wird bereitgestellt, um ihn mit einem weiteren Spenderwafer in Kontakt zu bringen.

Besonders hohe Materialverluste fallen bei der Herstellung von Mehrkomponentenwafern, wie z.B. sogenannten MEMS-Wafern (Microelectromechanical Systems Wafer) an. Die Herstellung derartiger Wafer setzt die Verwendung mehrerer sehr dicker Ausgangswafer voraus, deren Herstellung in der Regel bereits erhebliche Materialverluste bedingen. Die große Dicke der Ausgangswafer ist erforderlich, da nur so Bow und Warp gering genug gehalten werden können. Bei MEMS-Wafer dient ein Ausgangswafer üblicherweise dazu eine Oxidschicht auf einem weiteren Ausgangswafer unter Eingehung einer stoffschlüssigen Verbindung zu überdecken. Nach Erzeugung der stoffschlüssigen Verbindung erfolgt stets eine spanende Behandlung des Ausgangswafers, um dessen Dicke signifikant auf das zur Verwendung erforderliche geringere Maß zu reduzieren, wodurch wiederum Materialverluste entstehen.

Es ist somit Aufgabe der vorliegenden Erfindung den Materialverbrauch bei einer Mehrkomponentenwaferherstellung, insbesondere einer MEMS-Waferherstellung, zu reduzieren.

Die zuvor genannte Aufgabe wird erfindungsgemäß durch ein Verfahren gemäß Anspruch 1 gelöst.

Das erfindungsgemäße Verfahren umfasst dabei bevorzugt mindestens die Schritte: Bereitstellen eines Bondwafers, wobei zumindest ein Oberflächenanteil des Bondwafers durch eine Oxidschicht ausgebildet wird, Bereitstellen eines Spenderwafers, wobei der Spenderwafer dicker ist als der Bondwafer, In Kontakt bringen des Spenderwafers mit dem durch die Oxidschicht gebildeten Oberflächenanteil des Bondwafers, Bilden einer Mehrschichtanordnung durch Verbinden des Spenderwafers und des Bondwafers im Bereich des Kontakts, Erzeugen von Modifikationen im Inneren des Spenderwafers zum Vorgeben eines Ablösebereichs zum Trennen der Mehrschichtanordnung in einen Abtrennteil und einen Verbindungsteil mittels mindestens einem Laserstrahl, wobei die Erzeugung der Modifikationen vor Bildung der Mehrschichtanordnung oder nach der Bildung der Mehrschichtanordnung erfolgt, Trennen der Mehrschichtanordnung entlang dem Ablösebereich infolge einer durch die Erzeugung einer ausreichenden Anzahl an Modifikationen bewirkten Schwächung der Mehrschichtanordnung oder infolge einer Erzeugung von mechanischen Spannungen in der Mehrschichtanordnung, wobei der Verbindungsteil am Bondwafer verbleibt und wobei der abgespaltete Abtrennteil eine größere Dicke aufweist als der Verbindungsteil. Zusätzlich können einzelne oder mehrere Schritte des zuvor genannten Verfahrens durch die nachfolgend genannten Schritte ergänzt Anordnen oder Erzeugen einer Spannungserzeugungsschicht an mindestens einer freiliegenden ebenen Oberfläche der Mehrschichtanordnung, thermisches Beaufschlagen der Spannungserzeugungsschicht zum Erzeugen von mechanischen Spannungen innerhalb der Mehrschichtanordnung, wobei die Spannungen in dem durch den Spenderwafer gebildeten Anteil der Mehrschichtanordnung so groß werden, dass sich im Spenderwafer ein Riss ausbildet, durch den der Spenderwafer in einen Abtrennteil und einen Verbindungsteil gespalten wird, wobei der Verbindungsteil am Bondwafer verbleibt und wobei der abgespaltete Abtrennteil eine größere Dicke aufweist als der Verbindungsteil.

Diese Lösung ist vorteilhaft, da der Spenderwafer nicht durch spanende Bearbeitung auf den Verbindungsanteil reduziert wird, sondern durch einen Riss in zwei Teile zerteilt wird und somit ein Abtrennteil entsteht, das weiter verwendet werden kann. Dies ermöglicht, dass die Ausgangswafer bzw. der Bondwafer und der Spenderwafer, die miteinander verbunden werden, zwar jeweils eine große Dicke aufweisen können, ohne dass dabei jedoch die aus dem Stand der Technik bekannten Materialverluste entstehen.

Weitere bevorzugte Ausführungsformen sind Gegenstand der nachfolgenden Beschreibungsteile und/oder der Unteransprüche.

Gemäß einer bevorzugten Ausführungsform der vorliegenden Erfindung weist das erfindungsgemäße Verfahren den Schritt des Reinigens des Abtrennteils und/oder den Schritt des Umwandelns des Abtrennteils durch eine Behandlung zumindest eines Oberflächenanteils und bevorzugt der gesamten Oberfläche des Abtrennteils in einen weiteren Bondwafer auf. Der so erzeugte Bondwafer wird dann besonders bevorzugt als weiterer Bondwafer zum in Kontakt bringen mit einem weiteren Spenderwafer bereitgestellt. Das erfindungsgemäße Verfahren umfasst außerdem Umwandeln des Abtrennteils durch eine Behandlung zumindest eines Oberflächenanteils des Abtrennteils in einen weiteren Bondwafer undBereitstellen des weiteren Bondwafers zum in Kontakt bringen mit einem weiteren Spenderwafer. Diese Ausführungsform ist vorteilhaft, da der Ausgangswafer nacheinander als Spenderwafer, d.h. zunächst als Spenderwafer, und als Bondwafer, d.h. nach der Verwendung als Spenderwafer, verwendet wird.

Die Behandlung umfasst gemäß einer weiteren bevorzugten Ausführungsform der vorliegenden Erfindung einen SiOx-Prozess, wodurch eine Oxidation des mindestens einen Oberflächenanteils des Bondwafers bewirkt wird. Diese Ausführungsform ist vorteilhaft, da auf einfache Weise die für einen Mehrkomponentenwafer, insbesondere einen MEMS-Wafer, erforderliche Oxidschicht definiert erzeugt wird. Es ist hierbei vorstellbar, dass in einem Behandlungsraum nacheinander oder zeitgleich eine Vielzahl an Wafern bzw. Abtrennteile zum Erzeugen der Oxidschicht/en behandelt werden.

Gemäß einer weiteren bevorzugten Ausführungsform der vorliegenden Erfindung hat der Spenderwafer eine erste Dicke D1, der Bondwafer eine zweite Dicke D2, der Abtrennteil eine dritte Dicke D3, und der Verbindungsteil eine vierte Dicke D4, wobei die Dicke D1 größer ist als die Summe der Dicken D3 und D4 und wobei die Summe der Dicken D3 und D4 größer ist als die Dicke D3 und wobei die Dicke D3 um eine Dicke DL größer ist als die Dicke D2. Die Dicke D2 ist hierbei bevorzugt größer als 300 µm und bevorzugt größer als 400 µm oder 500 µm oder 600 µm oder 700 µm Diese Ausführungsform ist vorteilhaft, da sehr stabile Elemente, wie der Bondwafer, der Spenderwafer und/oder der Abtrennteil, verwendet werden können, wodurch diese Elemente z.B. den bei einem optionalen Polierschritt entstehenden mechanischen Belastungen standhalten. Ferner bilden solch dicke Elemente bzw. Wafer deutlich geringer Warps und Bows aus als dünnere Wafer.

Die Dicke DL beträgt gemäß einer weiteren bevorzugten Ausführungsform der vorliegenden Erfindung weniger als 200µm, insbesondere weniger als 100µm, wie z.B. weniger als 90 µm oder weniger als 80 µm oder weniger als 70 µm oder weniger als 60 µm oder weniger als 50 µm, und wird bevorzugt infolge von Polier- und/oder Ätzschritten entfernt bzw. ist so groß, wie die Materialanteile, die mittels polierender und/oder ätzender Behandlung entfernten werden. Diese Ausführungsform ist vorteilhaft, da eine für die Oberflächenbehandlung erforderliche Dicke bereitgestellt wird, die ausreicht, um eine ebene Oberfläche zu schaffen und dabei nur äußerst geringe Materialverluste bedingt.

Gemäß der vorliegenden Erfindung umfasst das erfindungsgemäße Verfahren den Schritt des Erzeugens von Modifikationen zum Vorgeben des Rissverlaufs. Die Erzeugung der Modifikationen erfolgt vor Bildung der Mehrschichtanordnung. Die Modifikationen werden dabei mittels Laserstrahlen im Inneren des Spenderwafers erzeugt. Die Laserstrahlen werden dabei bevorzugt von einer LASER-Einrichtung emittiert, wobei die LASER-Einrichtung bevorzugt ein Picosekundenlaser oder ein Femtosekundenlaser ist. Außerhalb der Erfindung ist denkbar, dass die Modifikationen lokale Risse im Kristallgitter und/oder infolge einer Behandlung in eine andere Phase überführte Materialanteile im Inneren des Spenderwafers sind.

Die LASER-Einrichtung umfasst gemäß einer weiteren bevorzugten Ausführungsform der vorliegenden Erfindung einen Femtosekunden-LASER (fs-LASER) und die Energie der LASER-Strahlen des fs-LASER wird bevorzugt derart gewählt, dass die Schädigungsausbreitung einer jeden Modifikation in der Nutzschicht und/oder der Opferschicht kleiner als 3 mal die Rayleighlänge, bevorzugt kleiner als die Rayleighlänge und besonders bevorzugt kleiner ein Drittel mal die Rayleighlänge ist und/oder die Wellenlänge der LASER-Strahlen des fs-LASER wird derart gewählt, dass die Absorption der Nutzschicht und/oder der Opferschicht kleiner als 10cm⁻¹ und bevorzugt kleiner als 1cm⁻¹ und besonders bevorzugt kleiner als 0,1cm⁻¹ ist und/oder die einzelnen Modifikationen ergeben sich jeweils in Folge einer von dem fs-LASER bewirkten multi-photonen Anregung.

Die Laserstrahlen zum Erzeugen der Modifikationen dringen über eine Oberfläche in den Spenderwafer ein, die Bestandteil des Verbindungsteils ist bzw. die zu dem Anteil gehört, der nach dem Zerteilen des Spenderwafers in zwei Anteile infolge einer Rissführung dünner ist als der andere Anteil. Dies ist vorteilhaft, da die Laserstrahlen sich weniger weit durch einen Festkörper bewegen müssen als wenn sie sich durch den anderen Anteil bewegen müssten. Hierdurch ist insbesondere eine laserseitige Energieeinsparung möglich und eine unerwünschte Aufheizung des Spendersubstrats infolge der Modifikationserzeugung wird bevorzugt reduziert.

Das erfindungsgemäße Verfahren umfasst bevorzugt u.a. den Schritte des Anordnens oder Erzeugens einer Spannungserzeugungsschicht an mindestens einer freiliegenden Oberfläche der Mehrschichtanordnung und den Schritt des Thermischen Beaufschlagens der Spannungserzeugungsschicht zum Erzeugen der mechanischen Spannungen innerhalb der Mehrschichtanordnung, wobei die Spannungen in dem durch den Spenderwafer gebildeten Anteil der Mehrschichtanordnung so groß werden, dass sich im Spenderwafer ein Riss entlang des Ablösebereichs ausbildet, durch den der Spenderwafer in den Abtrennteil und den Verbindungsteil gespalten wird, wobei die Spannungserzeugungsschicht ein Polymer, insbesondere Polydimethylsiloxan (PDMS), aufweist oder daraus besteht, wobei die thermische Beaufschlagung derart erfolgt, dass das Polymer einen Glasübergang erfährt, wobei die Spannungserzeugungsschicht, insbesondere mittels flüssigem Stickstoff, auf eine Temperatur unterhalb der Raumtemperatur oder unterhalb von 0°C oder unterhalb von -50°C oder unterhalb von -100°C oder unterhalb von -110°C, insbesondere auf eine Temperatur unterhalb der Glasübergangstemperatur der Spannungserzeugungsschicht, temperiert wird.

Diese Ausführungsform ist vorteilhaft, da erkannt wurde, dass durch die thermische Beaufschlagung der Spannungserzeugungsschicht, insbesondere durch Ausnutzung der beim Glasübergang auftretenden Eigenschaftsveränderungen des Materials der Spannungserzeugungsschicht, die zur Rissauslösung und Rissführung erforderlichen Kräfte in einem Spendersubstrat erzeugt werden können. Ferner kann durch die thermische Beaufschlagung der Spannungserzeugungsschicht zeitlich sehr genau gesteuert werden, wann die Abtrennung der Festkörperlage bzw. Festkörperschicht bzw. die Zerteilung der Mehrschichtanordnung erfolgt.

Die mechanischen Spannungen können zusätzlich oder alternativ durch gesamtmechanische Schwingungen und/oder Temperaturveränderungen und/oder Druckänderungen, insbesondere Luftdruckänderungen. Erzeugt werden.

Das Substrat bzw. der Spenderwafer weist bevorzugt ein Material oder eine Materialkombination aus einer der Hauptgruppen 3, 4 und 5 des Periodensystems der Elemente auf, wie z.B. Si, SiC, SiGe, Ge, GaAs, InP, GaN, Al2O3 (Saphir), AIN bzw. besteht aus einem oder mehreren dieser Materialien. Besonders bevorzugt weist das Substrat bzw. der Spenderwafer eine Kombination aus in der dritten und fünften Gruppe des Periodensystems vorkommenden Elementen auf. Denkbare Materialien oder Materialkombinationen sind dabei z.B. Galliumarsenid, Silizium, Siliziumcarbid, etc. Weiterhin kann das Substrat bzw. der Spenderwafer eine Keramik (z.B. Al2O3 - Alumiumoxid) aufweisen oder aus einer Keramik bestehen, bevorzugte Keramiken sind dabei z.B. Perovskitkeramiken (wie z.B. Pb-, O-, Ti/Zr-haltige Keramiken) im Allgemeinen und Blei-Magnesium-Niobate, Bariumtitanat, Lithiumtitanat, Yttrium-Aluminium-Granat, insbesondere Yttrium-Aluminium-Granat Kristalle für Festkörperlaseranwendungen, SAW-Keramiken (surface acoustic wave), wie z.B. Lithiumniobat, Galliumorthophosphat, Quartz, Calziumtitanat, etc. im Speziellen. Das Substrat bzw. der Spenderwafer weist somit bevorzugt ein Halbleitermaterial oder ein Keramikmaterial auf bzw. besonders bevorzugt besteht das Substrat bzw. der Spenderwafer aus mindestens einem Halbleitermaterial oder einem Keramikmaterial. Es ist weiterhin denkbar, dass das Substrat bzw. der Spenderwafer ein transparentes Material aufweist oder teilweise aus einem transparenten Material, wie z.B. Saphir, besteht bzw. gefertigt ist. Weitere Materialien, die hierbei als Festkörpermaterial alleine oder in Kombination mit einem anderen Material in Frage kommen, sind z.B. "wide band gap"-Materialien, InAISb, Hochtemperatursupraleiter, insbesondere seltene Erden Cuprate (z.B. YBa2Cu3O7).

Weiterhin bezieht sich die vorliegende Erfindung gemäß Anspruch 9 auf eine Verwendung eines Substrats als Spenderwafer und Bondwafer in einem Mehrkomponentenwaferherstellungsverfahren, insbesondere einem MEMS-Waferherstellungsverfahren. Das Substrat wird dabei bevorzugt als Spenderwafer an einen weiteren Bondwafer, der eine Oxidationsschicht aufweist, angeordnet, wobei der Spenderwafer unter Aufspaltung in einen Verbindungsteil und einen Abtrennteil infolge einer Rissausbreitung geteilt wird, und wobei der Abtrennteil nach einer Behandlung in einem Oxidationsprozess, insbesondere einem SiOx-Prozess, als Bondwafer dient, wobei der Bondwafer zum Ausbilden einer Mehrschichtanordnung mit einem weiteren Spendersubstrat verbunden wird.

Die vorliegende Beschreibung offenbart ferner einen Mehrkomponentenwafer, insbesondere einen MEMS-Wafer. Der Mehrkomponentenwafer umfasst dabei mindestens einen Bondwafer, wobei zumindest ein Oberflächenanteil des Bondwafers durch eine Oxidschicht ausgebildet wird, einen von einem Spenderwafer infolge einer Rissausbreitung abgespalteten Verbindungsteil, wobei der Verbindungsteil an einem durch die Oxidschicht ausgebildeten Oberflächenanteil stoffschlüssig angeordnet ist, und wobei der Bondwafer ein mittels einer Oxidationsbehandlung, insbesondere einer SiOx-Behandlung, aufbereiteter Anteil eines von einem Spenderwafer abgetrennten Abtrennteils ist. Diese Mehrkomponentenwafer können alternativ z.B. als MEMS-Wafer oder als Silicon on Insulator-Wafer oder als Mehrschichtwafer oder als Wafer mit innenliegender Bondingschicht bezeichnet werden. Wesentlich ist hierbei lediglich, dass eine Oxidschicht als Insulatorschicht oder Bondingschicht oder Ätzstopschicht zwischen zwei weiteren Schichten oder Materialanteilen geschaffen oder erzeugt oder ausgebildet oder bewirkt oder angeordnet wird. Die weiteren Schichten oder Materialanteile bilden dabei besonders bevorzugt zum einen den Bondwafer und zum anderen den Spenderwafer aus. Bevorzugt bestehen der Bondwafer und der Spenderwafer in den die Insulatorschicht oder Bondingschicht oder Ätzstopschicht benachbarenden Anteilen aus demgleichen Material und/oder aus einem Halbleitermaterial. Es ist jedoch ebenfalls denkbar, dass der Bondwafer und der Spenderwafer in den die Insulatorschicht oder Bondingschicht oder Ätzstopschicht benachbarenden Anteilen aus verschiedenen Materialien, insbesondere aus einem oder mehreren Halbleitermaterialien, besteht oder diese Materialien aufweist. Bevorzugt weist die Oxidschicht, die besonders bevorzugt als Insulatorschicht oder Bondingschicht oder Ätzstopschicht dient, eine Dicke, insbesondere eine durchschnittliche Dicke oder eine minimale Dicke oder eine maximale Dicke, von mindestens oder genau oder maximal 1,25 µm oder 1,5 µm oder 1,75 µm oder 2 µm oder 2,25 µm oder 2,5 µm oder 2,75 µm oder 3 µm oder 4 µm oder 5 µm oder 6 µm oder 7 µm oder 7,5 µm oder 8 µm oder 9 µm oder 10 µm auf. In einer bevorzugten Ausführungsform umfasst das erfindungsgemäße Verfahren u.a. die Schritte: Bereitstellen eines Spendersubstrats oder einer Mehrschichtanordnung, Erzeugen von Modifikationen im Inneren des Spendersubstrats bzw. der Mehrschichtanordnung mittels LASER-Strahlen, wobei durch die Modifikationen ein Ablösebereich vorgegeben wird, entlang dem eine Abtrennung der Festkörperlage von dem Spendersubstrat bzw. der Mehrschichtanordnung erfolgt, Abtragen von Material des Spendersubstrats bzw. der Mehrschichtanordnung ausgehend von einer sich in Umfangsrichtung des Spendersubstrats erstreckenden Oberfläche in Richtung Zentrum des Spendersubstrats bzw. der Mehrschichtanordnung, insbesondere zum Erzeugen einer umlaufenden Vertiefung, wobei durch den Materialabtrag der Ablösebereich freigelegt wird, Abtrennen der Festkörperlage von dem Spendersubstrat bzw. der Mehrschichtanordnung, wobei das Spendersubstrat bzw. die Mehrschichtanordnung im Ablösebereich durch die Modifikationen derart geschwächt wird, dass sich die Festkörperlage infolge des Materialabtrags von dem Spendersubstrat bzw. der Mehrschichtanordnung ablöst oder nach dem Materialabtrag eine solche Anzahl an Modifikationen erzeugt wird, dass das Spendersubstrat bzw. die Mehrschichtanordnung im Ablösebereich derart geschwächt wird, dass sich die Festkörperlage von dem Spendersubstrat bzw. der Mehrschichtanordnung ablöst oder eine Spannungserzeugungsschicht an einer zur umlaufenden Oberfläche geneigt ausgerichteten, insbesondere ebenen, Oberfläche des Spendersubstrats bzw. der Mehrschichtanordnung erzeugt oder angeordnet wird und durch ein thermisches Beaufschlagen der Spannungserzeugungsschicht mechanische Spannungen in dem Spendersubstrat bzw. in der Mehrschichtanordnung erzeugt werden, wobei durch die mechanischen Spannungen ein Riss zum Abtrennen einer Festkörperlage entsteht, der sich ausgehend von der durch den Materialabtrag freigelegten Oberfläche des Spendersubstrats bzw. der Mehrschichtanordnung entlang der Modifikationen ausbreitet.

Diese Lösung ist vorteilhaft, da sich ein Rand des Spendersubstrats bzw. der Mehrschichtanordnung, in dessen/deren Bereich sich nur sehr aufwendig Modifikationen zur weiteren Ausbildung des Ablösebereichs erzeugen lassen, entfernen oder reduzieren oder modifizieren lässt. Hierdurch erfolgt somit ein radialer Materialabtrag, durch den der Abstand der umlaufenden Oberfläche zum Ablösebereich reduziert wird.

Weitere bevorzugte Ausführungsformen sind Gegenstand der Unteransprüche und/oder der nachfolgenden Beschreibungsteile.

Der durch die Modifikationen vorgegebene Ablösebereich ist gemäß einer weiteren bevorzugten Ausführungsform der vorliegenden Erfindung vor dem Materialabtrag weiter zur umlaufenden Oberfläche des Spendersubstrats beabstandet als nach dem Materialabtrag. Diese Ausführungsform ist vorteilhaft, da der Ablösebereich somit einfach zu erzeugen ist und dennoch nach dem Materialabtrag bevorzugt an der äußeren umlaufenden Oberfläche des Spendersubstrats angrenzt.

Die Modifikationen zum Vorgeben des Ablösebereichs werden gemäß einer weiteren bevorzugten Ausführungsform der vorliegenden Erfindung vor dem Materialabtrag erzeugt und durch den Materialabtrag wird zumindest stellenweise eine Reduzierung des Abstands des Ablösebereichs auf weniger als 10mm, insbesondere auf weniger als 5mm und bevorzugt auf weniger als 1mm, erreicht oder die Modifikationen zum Vorgeben des Ablösebereichs werden nach dem Materialabtrag erzeugt, wobei die Modifikationen derart erzeugt werden, dass der Ablösebereich zumindest stellenweise weniger als 10mm, insbesondere weniger als 5mm und bevorzugt weniger als 1mm, zu einer durch den Materialabtrag freigelegten Oberfläche beabstandet ist. Besonders bevorzugt sind zumindest einzelne Modifikationen des Ablösebereichs Bestandteil der durch den Materialabtrag freigelegten und zumindest teilweise und bevorzugt vollständig umlaufenden Oberfläche des Spendersubstrats.

Gemäß einer weiteren bevorzugten Ausführungsform der vorliegenden Erfindung wird das Material mittels Ablations- Strahlen, insbesondere Ablations-LASER-Strahlen, oder Ablations-Fluiden entfernt oder durch den Materialabtrag wird eine Vertiefung mit einer asymmetrischen Gestalt erzeugt, oder der Materialabtrag erfolgt zumindest abschnittsweise in Umfangsrichtung des Spendersubstrats im gesamten Bereich zwischen dem Ablösebereich und einer zum Ablösebereich homogen beabstandeten Oberfläche des Spendersubstrats als eine Reduzierung des radialen Erstreckung des Spendersubstrats.

Die zuvor genannte Aufgabe kann zusätzlich oder alternativ durch ein Verfahren zum Abtrennen von Festkörperscheiben von einem Spendersubstrat gelöst werden, das dabei bevorzugt mindestens die nachfolgend genannten Schritte umfasst: Bereitstellen eines Spendersubstrats, Abtragen von Material des Spendersubstrats ausgehend von einer sich in Umfangsrichtung des Spendersubstrats erstreckenden Oberfläche in Richtung Zentrum des Spendersubstrats zum Erzeugen einer Vertiefung, wobei das Material mittels Ablations-LASER-Strahlen entfernt wird und/oder die Vertiefung asymmetrisch erzeugt wird Erzeugen von Modifikationen mittels weiterer LASER-Strahlen im Inneren des Spendersubstrats, wobei die Modifikationen derart positioniert werden, dass sie sich an die Vertiefung anschließen, wobei sich die Festkörperscheibe durch die erzeugten Modifikationen von dem Spendersubstrat ablöst oder eine Spannungserzeugungsschicht an einer zur umlaufenden Oberfläche geneigt ausgerichteten, insbesondere ebenen, Oberfläche erzeugt oder angeordnet wird und durch ein thermisches Beaufschlagen der Spannungserzeugungsschicht mechanische Spannungen in dem Spendersubstrat erzeugt werden, wobei durch die mechanischen Spannungen ein Riss zum Abtrennen einer Festkörperschicht entsteht, der sich ausgehend von der Vertiefung entlang der Modifikationen ausbreitet.

Die Modifikationen werden hierbei bevorzugt mit möglichst kurzen Pulsen in möglichst kleinem vertikalen Bereich durch Fokussierung im Material mit hoher numerischer Apertur erreicht.

Bei der Ablation werden die Ablations-LASER-Strahlen an der Oberfläche des Materials fokussiert, mit einer geringeren numerischen Apertur und oft einer Wellenlänge, die vom Material linear absorbiert wird. Die lineare Absorption der Ablations-LASER-Strahlen an der Materialoberfläche führt zu einer Verdampfung des Materials, der Ablation, also einem Materialabtrag, nicht nur einer Strukturveränderung

Diese Lösung ist vorteilhaft, da ein Randbereich des Spendersubstarts mittels einer materialabtragenden Behandlung bearbeitet wird, durch die der äußere Rand des Spendersubstrats im Bereich der Ebene, in der sich der Riss ausbreitet, in Richtung Zentrum des Spendersubstrats verlagert wird. Die Verlagerung erfolgt bevorzugt soweit in Richtung Zentrum, dass in Abhängigkeit der Eindringtiefe der LASER-Strahlen und/oder der Winkel der LASER-Strahlen zueinander alle LASER-Strahlen über dieselbe ebene Oberfläche in das Spendersubstrat eindringen können.

Die Vertiefung umgibt das Spendersubstrats gemäß einer weiteren bevorzugten Ausführungsform der vorliegenden Erfindung vollständig in Umfangsrichtung. Diese Ausführungsform ist vorteilhaft, da der Riss über den gesamten Umfang des Spendersubstrats definiert in das Spendersubstrat einleitbar ist.

Die Vertiefung verläuft gemäß einer weiteren bevorzugten Ausführungsform der vorliegenden Erfindung in Richtung Zentrum bis zu einem Vertiefungsende hin enger werdend, insbesondere keil- oder kerbförmig, wobei das Vertiefungsende in der Ebene liegt, in der sich der Riss ausbreitet. Diese Ausführungsform ist vorteilhaft, da durch das Vertiefungsende eine Kerbe schaffen wird, durch welche die Ausbreitrichtung des Risses vorgegeben wird.

Die asymmetrische Vertiefung wird gemäß einer weiteren bevorzugten Ausführungsform der vorliegenden Erfindung mittels eines zur Vertiefung zumindest abschnittsweise negativ geformten Schleifwerkzeugs erzeugt. Diese Ausführungsform ist vorteilhaft, das Schleifwerkzeug gemäß der zu erzeugenden Kante bzw. Vertiefung herstellbar ist.

Das Schleifwerkzeug weist gemäß einer weiteren bevorzugten Ausführungsform der vorliegenden Erfindung mindestens zwei verschieden geformte Bearbeitungsanteile auf, wobei ein erster Bearbeitungsanteil zum Bearbeiten des Spendersubstrats im Bereich der Unterseite einer abzutrennenden Festkörperscheibe und ein zweiter Bearbeitungsanteil zum Bearbeiten des Spendersubstrats im Bereich der Oberseite der von dem Spendersubstrat abzutrennenden Festkörperscheibe bestimmt ist. Diese Ausführungsform ist vorteilhaft, da mittels des Schleifwerkzeugs neben Umformungen zum Bewirken einer verbesserten Rissführung ebenfalls Umformungen zur besseren Handhabung zeitgleich oder zeitversetzt an dem Spendersubstart bzw. an den eine oder mehrere Festkörperscheibe/n ausbildenden Anteilen des Spendersubstrats bewirkt werden können.

Gemäß einer weiteren bevorzugten Ausführungsform der vorliegenden Erfindung erzeugt der erste Bearbeitungsanteil eine tiefere oder volumenmäßig größere Vertiefung in dem Spendersubstrat als der zweite Bearbeitungsanteil, wobei der erste Bearbeitungsanteil und/oder der zweite Bearbeitungsanteil gebogene oder gerade Schleifflächen aufweisen. Bevorzugt weist der erste Bearbeitungsanteil eine gebogene Hauptschleiffläche auf und der zweite Bearbeitungsanteil weist bevorzugt ebenfalls eine gebogene Nebenschleiffläche auf, wobei der Radius der Hauptschleiffläche größer ist als der Radius der Nebenschleiffläche, bevorzugt ist der Radius der Hauptschleiffläche mindestens doppelt so groß wie der Radius der Nebenschleiffläche oder der erste Bearbeitungsanteil weist eine gerade Hauptschleiffläche auf und der zweite Bearbeitungsanteil weist eine gerade Nebenschleiffläche auf, wobei mittels der Hauptschleiffläche mehr Material als mit der Nebenschleiffläche von dem Spendersubstrat entfernt wird oder der erste Bearbeitungsanteil weist eine gerade Hauptschleiffläche auf und der zweite Bearbeitungsanteil weist eine gebogene Nebenschleiffläche auf oder der erste Bearbeitungsanteil weist eine gebogene Hauptschleiffläche auf und der zweite Bearbeitungsanteil weist eine gerade Nebenschleiffläche auf.

Bevorzugt weist das Schleifwerkezeug eine Vielzahl, insbesondere mehr als 2, 3, 4, 5, 6, 7, 8, 9 oder 10, an Bearbeitungsanteilen auf, um eine entsprechende Vielzahl an unterschiedlichen Festkörperscheiben zuordenbaren Anteile des Spendersubstrats spanend bzw. materialentfernend zu bearbeiten.

Gemäß einer weiteren bevorzugten Ausführungsform der vorliegenden Erfindung werden die Ablations-LASER-Strahlen mit einer Wellenlänge im Bereich zwischen 300 nm (UV-Ablation mit frequenzverdreifachtem Nd:YAG- oder anderem Festkörperlaser) und 10 µm (CO₂-Gaslaser, oft für Gravur und Schneidprozesse verwendet), mit einer Pulsdauer von weniger als 100 Mikrosekunden und bevorzugt von weniger als 1 Mikrosekunde und besonders bevorzugt von weniger als 1/10 Mikrosekunde und mit einer Pulsenergie von mehr als 1µJ und bevorzugt von mehr als 10 µJ erzeugt. Diese Ausführungsform ist vorteilhaft, da mittels einer LASER-Einrichtung und nicht mittels eines sich abnutzenden Schleifwerkezeugs die Vertiefung erzeugbar ist.

Die Modifikationen im Spendersubstrat werden materialabhängig bevorzugt mit den nachfolgend angeführten Konfigurationen bzw. LASER-Parametern erzeugt: Besteht das Spendersubstrat aus Silizium oder weist das Spendersubstart Silizium auf, so werden bevorzugt Nanosekundenpulse oder kürzer(<500ns), eine Pulsenergie im Mikrojoulebereich (<100µJ) und eine Wellenlänge >1000nm verwendet.

Bei allen anderen Materialien und Materialkombinationen werden bevorzugt Pulse <5 Pikosekunden, Pulsenergien im Mikrojoulebereich (<100µJ) und Wellenlängen Wellenlängen variabel zwischen 300nm und 2500nm verwendet.

Wichtig ist hierbei, dass eine große Apertur vorgesehen wird, um tief ins Material zu gelangen. Die Apertur zur Erzeugung der Modifikationen im Inneren des Spendersubstrats ist somit bevorzugt größer als die Apertur zur Ablation von Material mittels der Ablations-LASER-Strahlen zum Erzeugen der Vertiefung. Bevorzugt ist die Apertur mindestens um ein Vielfaches, insbesondere mindestens um das 2, 3, 4, 5, 6-fache größer als die Apertur zur Ablation von Material mittels der Ablations-LASER-Strahlen zum Erzeugen der Vertiefung. Die Fokusgröße zur Erzeugung einer Modifikation ist, insbesondere hinsichtlich ihres Durchmessers, bevorzugt kleiner als 10µm, bevorzugt kleiner als 5µm und besonders bevorzugt kleiner als 3µm. Eine Ausführungsform der Erfindung kann sich auf ein Verfahren zum Abtrennen von Festkörperscheiben von einem Spendersubstrat beziehen, wobei die LASER-Strahlen über eine ebene Oberfläche des Spendersubstrats in das Spendersubstrat eindringen, wobei die Gesamtheit der LASER-Strahlen derart gegenüber der Oberfläche des Spendersubstrats geneigt ist, dass ein erster Anteil der LASER-Strahlen in einem ersten Winkel zur Oberfläche des Spendersubstrats in das Spendersubstrat eindringt und mindestens ein weiterer Anteil in einem zweiten Winkel zur Oberfläche des Spendersubstrats in das Spendersubstrat eindringt, wobei sich der Betrag des ersten Winkels von dem Betrag des zweiten Winkels unterscheidet, wobei der erste Anteil der LASER-Strahlen und der zweite Anteil der LASER-Strahlen zum Erzeugen der Modifikation im Spendersubstrat fokussiert werden, wobei sich die Festkörperscheibe durch die erzeugten Modifikationen von dem Spendersubstrat ablöst oder eine Spannungserzeugungsschicht an der ebenen Oberfläche des Spendersubstrats erzeugt oder angeordnet wird und durch ein thermisches Beaufschlagen der Spannungserzeugungsschicht mechanische Spannungen in dem Spendersubstrat erzeugt werden, wobei durch die mechanischen Spannungen ein Riss zum Abtrennen einer Festkörperschicht entsteht, der sich entlang der Modifikationen ausbreitet. Bevorzugt wird der Spenderwafer und/oder die die LASER-Strahlen emittierende LASER-Einrichtung während der Erzeugung der Modifikationen um eine Rotationsachse rotiert. Besonders bevorzugt erfolgt zusätzlich oder alternativ zur Rotation des Spenderwafers eine Veränderung des Abstandes der LASER-Strahlen zum Zentrum des Spenderwafers.

Die Gesamtheit der LASER-Strahlen ist gemäß einer weiteren bevorzugten Ausführungsform der vorliegenden Erfindung für die Erzeugung von Modifikationen im Bereich des Zentrums des Spendersubstrats und für die Erzeugung von Modifikationen im Bereich eines sich in radialer Richtung ergebenden Rands des Spendersubstrats in derselben Ausrichtung gegenüber der ebenen Oberfläche des Spendersubstrats ausgerichtet.

Diese Lösung ist vorteilhaft, da der gesamte Querschnitt des Laserstrahls beim Eintritt in den Festkörper eine ebene Fläche trifft, da dann in der Tiefe eine homogene Schädigung auftritt. Diese homogene Schädigung ist bis an den äußeren, insbesondere sich orthogonal zur ebenen Oberfläche erstreckenden, Rand des Spendersubstrats erzeugbar. Somit können die Modifikationen um Randbereich des Spendersubstrats und im Bereich des Zentrums des Spendersubstrats mittels eines Bearbeitungsschritts erzeugt werden.

Der erste Anteil der LASER-Strahlen dringt gemäß einer weiteren bevorzugten Ausführungsform der vorliegenden Erfindung in einem ersten Winkel zur Oberfläche des Spendersubstrats in das Spendersubstrat ein und der weitere Anteil der LASER-Strahlen dringt in einem zweiten Winkel für die Erzeugung von Modifikationen im Bereich des Zentrums des Spendersubstrats und für die Erzeugung von Modifikationen im Bereich eines sich in radialer Richtung ergebenden Rands des Spendersubstrats ein, wobei sich der Betrag des ersten Winkels von dem Betrag des zweiten Winkels stets unterscheidet. Bevorzugt sind der erste Winkel und der zweite Winkel während der Erzeugung der Modifikationen konstant bzw. unverändert bzw. werden nicht verändert.

Die LASER-Einrichtung umfasst gemäß einer weiteren bevorzugten Ausführungsform der vorliegenden Erfindung einen Femtosekunden-LASER (fs-LASER) oder einen Picosekunden-LASER (ps-LASER) und die Energie der LASER-Strahlen des LASER (fs-LASER oder ps-LASER) wird bevorzugt derart gewählt, dass die Schädigungsausbreitung einer jeden Modifikation in der Nutzschicht und/oder der Opferschicht kleiner als 3 mal die Rayleighlänge, bevorzugt kleiner als die Rayleighlänge und besonders bevorzugt kleiner ein Drittel mal die Rayleighlänge ist und/oder die Wellenlänge der LASER-Strahlen des fs-LASER wird derart gewählt, dass die Absorption der Nutzschicht und/oder der Opferschicht kleiner als 10cm⁻¹ und bevorzugt kleiner als 1cm⁻¹ und besonders bevorzugt kleiner als 0,1cm⁻¹ ist und/oder die einzelnen Modifikationen ergeben sich jeweils in Folge einer von dem fs-LASER bewirkten multi-photonen Anregung.

Die LASER-Strahlen zum Erzeugen der Modifikationen dringen über eine Oberfläche in den Spenderwafer ein, die Bestandteil der abzutrennenden Festkörperscheibe ist. Dies ist vorteilhaft, da eine geringere Aufheizung des Spendersubstrats erfolgt, wodurch dieses nur geringen thermischen Spannungen ausgesetzt wird.

Gemäß einer weiteren bevorzugten Ausführungsform der vorliegenden Erfindung umfasst die Ablations-Strahlung beschleunigte Ionen und/oder Plasma und/oder LASER-Strahlen und/oder wird durch Elektronenstrahlheizen oder Ultraschallwellen gebildet und/oder ist Bestandteil eines lithografischen Verfahrens (Elektronenstrahl, UV, Ionen, Plasma) mit mindestens einem Ätzschritt nach zuvor erfolgter Fotolackbeschichtung und/oder das Ablations-Fluid ist ein Flüssigkeitsstrahl, insbesondere ein Wasserstrahl eines Wasserstrahlschneidprozesses.

Die Spannungserzeugungsschicht weist gemäß einer weiteren bevorzugten Ausführungsform der vorliegenden Erfindung ein Polymer, insbesondere Polydimethylsiloxan (PDMS), auf oder besteht daraus, wobei die thermische Beaufschlagung bevorzugt derart erfolgt, dass das Polymer einen Glasübergang erfährt, wobei die Spannungserzeugungsschicht, insbesondere mittels flüssigem Stickstoff, auf eine Temperatur unterhalb der Raumtemperatur (d.h. auf eine Temperatur von weniger als 20°C) oder unterhalb von 0°C oder unterhalb von -50°C oder unterhalb von -100°C oder unterhalb von -110°C, insbesondere auf eine Temperatur unterhalb der Glasübergangstemperatur der Spannungserzeugungsschicht, temperiert wird.

Diese Ausführungsform ist vorteilhaft, da erkannt wurde, dass durch die thermische Beaufschlagung der Spannungserzeugungsschicht, insbesondere durch Ausnutzung der beim Glasübergang auftretenden Eigenschaftsveränderungen des Materials der Spannungserzeugungsschicht, die zur Rissauslösung und Rissführung erforderlichen Kräfte in einem Spendersubstrat erzeugt werden können.

Das Spendersubstrat weist bevorzugt ein Material oder eine Materialkombination aus einer der Hauptgruppen 3, 4 und 5 des Periodensystems der Elemente auf, wie z.B. Si, SiC, SiGe, Ge, GaAs, InP, GaN, Al2O3 (Saphir), AIN bzw. besteht aus einem oder mehreren dieser Materialien. Besonders bevorzugt weist das Spendersubstrat eine Kombination aus in der dritten und fünften Gruppe des Periodensystems vorkommenden Elementen auf. Denkbare Materialien oder Materialkombinationen sind dabei z.B. Galliumarsenid, Silizium, Siliziumcarbid, etc. Weiterhin kann das Spendersubstrat eine Keramik (z.B. Al2O3 - Alumiumoxid) aufweisen oder aus einer Keramik bestehen, bevorzugte Keramiken sind dabei z.B. Perovskitkeramiken (wie z.B. Pb-, O-, Ti/Zr-haltige Keramiken) im Allgemeinen und Blei-Magnesium-Niobate, Bariumtitanat, Lithiumtitanat, Yttrium-Aluminium-Granat, insbesondere Yttrium-Aluminium-Granat Kristalle für Festkörperlaseranwendungen, SAW-Keramiken (surface acoustic wave), wie z.B. Lithiumniobat, Galliumorthophosphat, Quartz, Calziumtitanat, etc. im Speziellen. Das Spendersubstrat weist somit bevorzugt ein Halbleitermaterial oder ein Keramikmaterial auf bzw. besonders bevorzugt besteht das Spendersubstrat aus mindestens einem Halbleitermaterial oder einem Keramikmaterial. Es ist weiterhin denkbar, dass das Spendersubstrat ein transparentes Material aufweist oder teilweise aus einem transparenten Material, wie z.B. Saphir, besteht bzw. gefertigt ist. Weitere Materialien, die hierbei als Festkörpermaterial alleine oder in Kombination mit einem anderen Material in Frage kommen, sind z.B. "wide band gap"-Materialien, InAlSb, Hochtemperatursupraleiter, insbesondere seltene Erden Cuprate (z.B. YBa2Cu3O7). DE 10 2013 113030 A1 offenbart ein Verfahren zur Kantenverrundung von Halbleiter-Wafern. Hierzu wird zwischen den äußeren umlaufenden Kanten des Halbleiter-Wafers im gleichen Arbeitsschritt, in welchem mindestens eine Kante des Halbleiter-Wafers verrundet wird, eine ebenfalls umlaufende Vertiefung erzeugt.

Die Verwendung der Wörter "im Wesentlichen" definiert bevorzugt in allen Fällen, in denen diese Wörter im Rahmen der vorliegenden Erfindung verwendet werden eine Abweichung im Bereich von 1%-30%, insbesondere von 1%-20%, insbesondere von 1%-10%, insbesondere von 1%-5%, insbesondere von 1%-2%, von der Festlegung, die ohne die Verwendung dieser Wörter gegeben wäre.

Weitere Vorteile, Ziele und Eigenschaften der vorliegenden Erfindung werden anhand nachfolgender Beschreibung anliegender Zeichnungen erläutert, in welchen beispielhaft die erfindungsgemäßen Lösungen dargestellt sind. Bauteile oder Elemente oder Verfahrensschritte der erfindungsgemäßen Lösungen, welche in den Figuren wenigstens im Wesentlichen hinsichtlich ihrer Funktion übereinstimmen, können hierbei mit gleichen Bezugszeichen gekennzeichnet sein, wobei diese Bauteile oder Elemente nicht in allen Figuren beziffert oder erläutert sein müssen.

Darin zeigen:
- Fig. 1: einen Mehrkomponentenwaferherstellungsprozess;
- Fig. 2: einen Teilprozess des erfindungsgemäßen Mehrkomponentenwaferherstellungsprozess,
- Fig. 3: einen weiteren oder ergänzten Mehrkomponentenwaferherstellungsprozess,
- Fig. 4: ein erstes Beispiel für eine Randbehandlung im Rahmen der Erfindung;
- Fig. 5: Beispiele von Konturen von Schleifwerkzeugen, wie sie gemäß dem in Fig. 4 gezeigten Verfahren eingesetzt werden können;
- Fig. 6: ein zweites Beispiel für eine Randbehandlung im Rahmen der Erfindung; und
- Fig. 7a-7d: ein drittes Beispiel für eine Randbehandlung im Rahmen der erfindung, und
- Fig. 8a-8b: Darstellung eines beim Erzeugen von Modifikationen mittels LASER-Strahlen im Randbereich eines Spendersubstrats oder Mehrschichtanordnung auftretenden Problems
- Fig. 9: ein Beispiel für eine Randbehandlung im Rahmen der erfindungsgemäßen Festkörperscheibenherstellung bzw. Festkörperlagenherstellung,
- Fig. 10: ein weiteres Beispiel für eine Randbehandlung im Rahmen der erfindungsgemäßen Festkörperscheibenherstellung bzw. Festkörperlagenherstellung,
- Fig. 11: eine Darstellung, die Probleme zeigt, die beim Erzeugen von Modifikationen in einem Festkörper auftreten, wenn die Modifikationen mittels LASER-Strahlen erzeugt werden,
- Fig. 12: eine Darstellung, die verschiedene LASER-Strahlwinkel zeigt,
- Fig. 13a/13b: eine Darstellung, eines Modifikationserzeugungsschrittes und eine schematische Darstellung der erzeugten Modifikationen,
- Fig. 14a/14b: zwei Darstellungen von Modifikationserzeugungsschritten, und
- Fig. 15: eine Modifikationserzeugung mit einer Aberrationsanpassung.

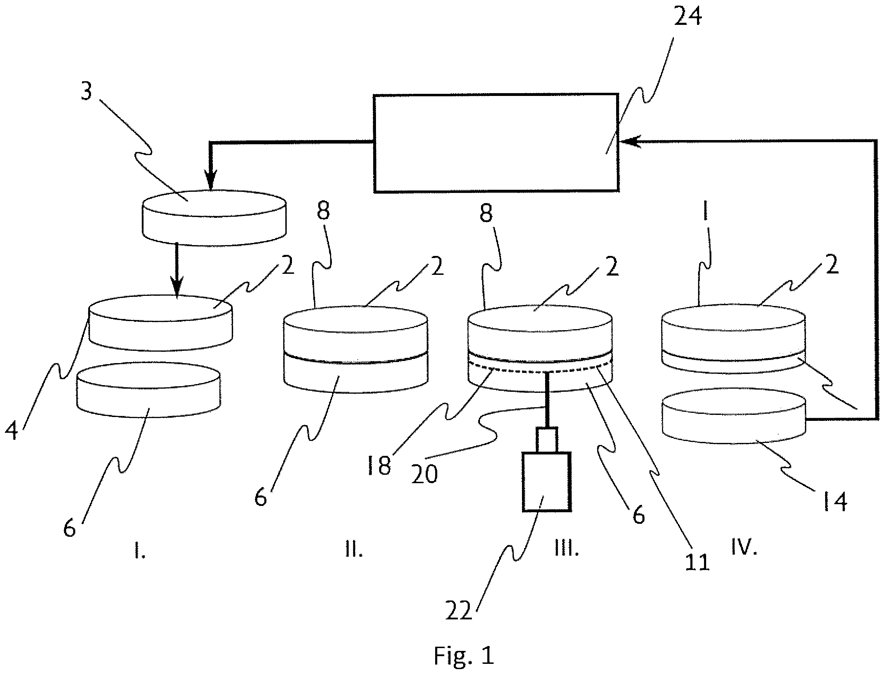

Fig. 1 zeigt mehrere Schritte eines Verfahren zur Herstellung eines Mehrkomponentenwafers 1, insbesondere eines MEMS-Wafers. Gemäß dieser Darstellung wird in einem ersten Schritt I. zunächst ein Bondwafer 2 bereitgestellt, wobei zumindest ein Oberflächenanteil 4 des Bondwafers 2 durch eine Oxidschicht ausgebildet wird. Ferner wird in dem ersten Schritt I. ein Spenderwafer 6 bereitgestellt, wobei der Spenderwafer 6 dicker ist als der Bondwafer.

In einem zweiten Schritt II. werden der Spenderwafer 6 mit dem durch die Oxidschicht gebildeten Oberflächenanteil 4 des Bondwafers 2 in Kontakt gebracht. Dies führt zur Bildung einer Mehrschichtanordnung 8 durch Verbinden des Spenderwafers 6 und des Bondwafers 2 im Bereich des Kontakts,

In einem dritten Schritt III. erfolgt das Erzeugen von Modifikationen 18 im Inneren des Spenderwafers 6 zum Vorgeben eines Ablösebereichs 11 zum Trennen der Mehrschichtanordnung 8 in einen Abtrennteil 14 und einen Verbindungsteil 16, wobei die Erzeugung der Modifikationen 18 vor Bildung der Mehrschichtanordnung 8 oder nach der Bildung der Mehrschichtanordnung 8 erfolgt.

Schritt IV. zeigt den Schritt des Trennens der Mehrschichtanordnung 8 entlang dem Ablösebereich 11 infolge einer durch die Erzeugung einer ausreichenden Anzahl an Modifikationen bewirkten Schwächung der Mehrschichtanordnung, wobei der Verbindungsteil 16 am Bondwafer 2 verbleibt und wobei der abgespaltete Abtrennteil 14 eine größere Dicke aufweist als der Verbindungsteil 16.

Das Abtrennteil 14 wird dann in einem weiteren Schritt einer Behandlungseinrichtung 24 zugeführt. Die Behandlungseinrichtung 24 erzeugt durch Materialaufbringung und/oder durch Materialumwandlung eine Oxidschicht, durch die mindestens eine bevorzugt ebene Oberfläche des Abtrennteils 14 ausgebildet wird.

Vor oder nach Erzeugung der Oxidschicht erfolgt bevorzugt ein materialabtragender Schritt, insbesondere ein Polieren, Läppen, Ätzen und/oder chemisch-mechanisches Polieren durch das zumindest eine Oberfläche oder ein Oberflächenanteil der Abtrennschicht 14 bzw. des Bondwafers 2 geglättet wird, d.h. zumindest teilweise eine Rauheitsreduzierung erfährt. Durch die Rauheitsreduzierung und die Oxidschichterzeugung, insbesondere einen SiOx-Prozess, wird der Abtrennteil 14 zu einem weiteren Bondwafer 3 umkonfiguriert. Dieser weitere Bondwafer 3 wird dann als Bondwafer 2 gemäß dem durch die Schritte I-IV beschriebenen Verfahren verwendet.

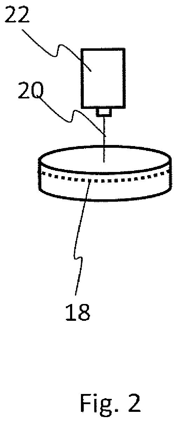

Fig. 2 zeigt die erfindungsgemäße Erzeugung der Modifikationen 18. Dabei werden die Modifikationen 18 vor dem Erzeugen einer Mehrschichtanordnung 8 erzeugt. Dies ist vorteilhaft, da die LASER-Strahlen 20 über eine Oberfläche des Spenderwafers 6 in den Spenderwafer 6 eindringen können, die nach dem Teilen des Spenderwafers 6 Bestandteil des Verbindungsteils 16 ist.

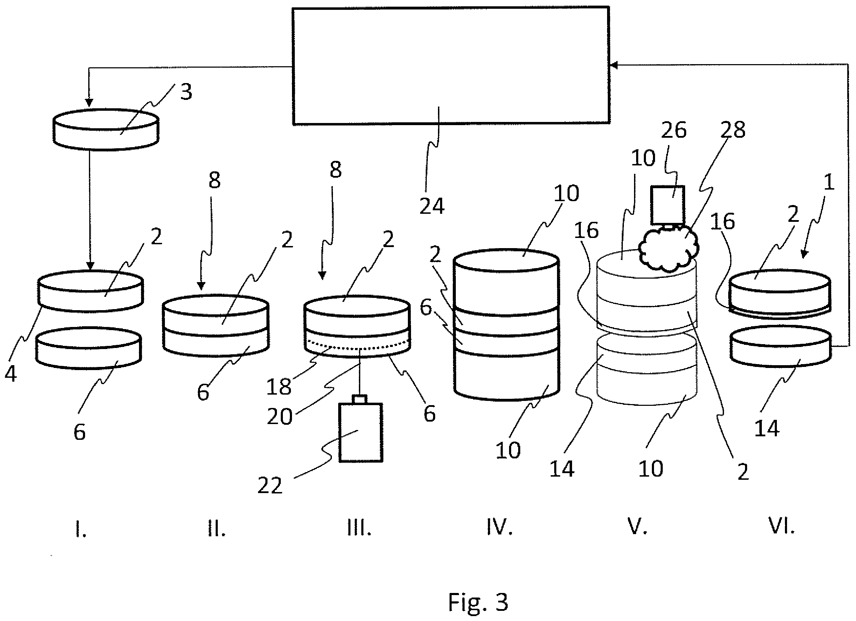

Fig. 3 zeigt einen weiteren bzw. weiter ergänzten erfindungsgemäßen Mehrkomponentenwaferherstellungsprozess, insbesondere einen MEMS-Waferherstellungsprozess. Gemäß diesem Mehrkomponentenwaferherstellungsprozess werden in einem ersten Schritt I. ein Bondwafer 2 und ein Spenderwafer 6 bereitgestellt. Der Bondwafer 2 weist dabei an bevorzugt mindestens einer Oberfläche, insbesondere an mindestens einer ebenen Oberfläche 4, eine Oxidschicht auf. Die Oxidschicht kann hierbei durch umwandeln des Ausgangsmaterials des Bondwafers 2 erzeugt sein oder durch Ablagerung bzw. Beschichtung erzeugt sein. Der Spenderwafer 6 weist bevorzugt keine Oxidschicht auf.

Im Schritt II. werden der Bondwafer 2 und der Spenderwafer 6 miteinander verbunden, insbesondere stoffschlüssig miteinander verbunden. Die Oxidschicht bzw. zumindest ein Teil der Oxidschicht des Bondwafers 2 wird dabei unmittelbar durch den Spenderwafer 6 überlagert bzw. abgedeckt. Die Oberfläche der Oxidschicht und die Oberfläche des Spenderwafers 6, die hierbei miteinander verbunden werden, weisen beide besonders bevorzugt eine durch Polieren, Läppen, Ätzen und/oder chemisch-mechanisches Polieren aufbereitete Oberflächengüte auf. Die mittlere Rauheit Ra ist hierbei bevorzugt geringer als 76 µm, oder geringer als 38 µm oder geringer als 12,5 µm oder geringer als 6 µm oder geringer als 3 µm oder geringer als 2,5 µm oder geringer als 1,25 µm oder geringer als 0,5 µm.

Im Schritt III. wird die Mehrschichtanordnung 8, insbesondere das Spendersubstrat 6, mit LASER-Strahlen 20 einer LASER-Einrichtung 22 beaufschlagt. Die LASER-Strahlen 20 bewirken, insbesondere aufgrund einer Mehrphotonenanregung, im Inneren des Spenderwafers 6, dass Modifikationen 18 des den Spenderwafer 6 bildenden Materials entstehen bzw. erzeugt werden. Bevorzugt wird eine Vielzahl an Modifikationen 18 erzeugt, wobei die einzelnen Modifikationen 18 bevorzugt in derselben Ebene liegen. Die Gesamtheit der Modifikationen 18 stellt somit eine präzise erzeugbare Schwächung des Spenderwafers 6 dar, die im Sinne einer Perforation, einen Rissführungsverlauf zum Trennen des Spenderwafers 6 in zwei Teile vorgibt. Die LASER-Strahlen 20 dringen gemäß dem gezeigten Beispiel über eine Oberfläche des Spenderwafers 6 in den Spenderwafer 6 ein die nach dem Spalten des Spenderwafers 6 in zwei Teile ein Bestandteil des dickeren Teils ist.

Die erfindungsgemäße Erzeugung von Modifikationen 18 wird jedoch durch Fig. 2 dargestellt.

Im Schritt IV. wird an einer bevorzugt weiteren freiliegenden und besonders bevorzugt ebenen Oberfläche des Bondwafers 2 und/oder an einer bevorzugt weiteren freiliegenden und besonders bevorzugt ebenen Oberfläche des Spenderwafers 6 eine Spannungserzeugungsschicht 10 angeordnet oder erzeugt. Die Spannungserzeugungsschicht 10 ist hierbei bevorzugt eine Polymerschicht, insbesondere eine Schicht bestehen aus PDMS oder PDMS aufweisend.

Im Schritt V. wird die an dem Bondwafer 2 und/oder die an dem Spenderwafer 6 angeordnete Spannungserzeugungsschicht 10 einer thermischen Beaufschlagung ausgesetzt, wodurch sich die Spannungserzeugungsschicht 10 zusammenzieht und dadurch mechanische Spannungen in die Mehrschichtanordnung 8 derart einleitet, dass sich im Bereich der Modifikationen 18 ein Riss ausbildet und ausbreitet. Die thermische Beaufschlagung erfolgt bevorzugt über eine Abkühleinrichtung 26, die besonders bevorzugt eine fließfähige Substanz 28 ausgibt, welche die Spannungserzeugungsschicht 10 abkühlt. Die fließfähige Substanz 28 ist hierbei bevorzugt ein Fluid und besonders bevorzugt flüssiger Stickstoff. Durch den Riss wird der Spenderwafer 6 in zwei Teile, einen Verbindungsteil 16 und einen Abtrennteil 14, aufgespaltet, wobei der Verbindungsteil 16 aufgrund der stoffschlüssigen Verbindung mit dem Bondwafer 2 an dem Bondwafer 2 verbleibt und der Abtrennteil 14 abgetrennt wird. Der Abtrennteil 14 und der Verbindungsteil 16 weisen beide eine waferartige Gestalt auf. Der Abtrennteil 14 ist bevorzugt dicker als der Verbindungsteil 16, bevorzugt ist der Abtrennteil 14 mindestens 1,25 mal oder mindestens 1,5 mal oder mindestens 1,75 mal oder mindestens 2 mal oder mindestens 2,25 mal oder mindestens 2,5 mal oder mindestens 2,75 mal oder mindestens 3 mal oder mindestens 3,25 mal oder mindestens 3,5 mal oder mindestens 3,75 mal oder mindestens 4 mal oder mindestens 4,25 mal oder mindestens 4,5 mal oder mindestens 4,75 mal oder mindestens 5 mal oder mindestens 5,25 mal oder mindestens 5,5 mal oder mindestens 5,75 mal oder mindestens 6 mal oder mindestens 6,25 mal so dick, wie der Verbindungsteil 16. Die Dicke des Verbindungsteils 16 bestimmt sich bevorzugt durch den mittleren Abstand der ebenen Oberflächen des Verbindungsteils 16 zueinander. Die Dicke des Abtrennteils 14 bestimmt sich bevorzugt durch den mittleren Abstand der ebenen Oberflächen des Abtrennteils 14 zueinander.

In Schritt VI werden die Spannungserzeugungsschichten 10 von dem erzeugten Mehrkomponentenwafer 1, insbesondere MEMS-Wafer 1, und bevorzugt ebenfalls von dem Abtrennteil 14 durch reinigen entfernt.

Das Abtrennteil 14 wird dann in einem weiteren Schritt einer Behandlungseinrichtung 24 zugeführt. Die Behandlungseinrichtung 24 erzeugt durch Materialaufbringung und/oder durch Materialumwandlung eine Oxidschicht, durch die mindestens eine bevorzugt ebene Oberfläche des Abtrennteils 14 ausgebildet wird.

Vor oder nach Erzeugung der Oxidschicht erfolgt bevorzugt ein materialabtragender Schritt, insbesondere ein Polieren, Läppen, Ätzen und/oder chemisch-mechanisches Polieren durch das zumindest eine Oberfläche oder ein Oberflächenanteil der Abtrennschicht 14 bzw. des Bondwafers 2 geglättet wird, d.h. zumindest teilweise eine Rauheitsreduzierung erfährt. Durch die Rauheitsreduzierung und die Oxidschichterzeugung wird der Abtrennteil 14 zu einem weiteren Bondwafer 3 umkonfiguriert. Dieser weitere Bondwafer 3 wird dann als Bondwafer 2 gemäß dem durch die Schritte I-VI beschriebenen Verfahren verwendet.

Die vorliegende Erfindung bezieht sich somit auf ein Verfahren zur Herstellung eines Mehrkomponentenwafers 1, insbesondere eines MEMS-Wafers 1. Das erfindungsgemäße Verfahren umfasst in dieser Variante also u.a. die Schritte: Bereitstellen eines Bondwafers 2, wobei zumindest ein Oberflächenanteil 4 des Bondwafers 2 durch eine Oxidschicht ausgebildet wird, Bereitstellen eines Spenderwafers 6, wobei der Spenderwafer 6 dicker ist als der Bondwafer 2, In Kontakt bringen des Spenderwafers 6 mit dem durch die Oxidschicht gebildeten Oberflächenanteil 4 des Bondwafers 2, Bilden einer Mehrschichtanordnung 8 durch Verbinden des Spenderwafers 6 und des Bondwafers 2 im Bereich des Kontakts, Anordnen oder Erzeugen einer Spannungserzeugungsschicht 10 an mindestens einer freiliegenden ebenen Oberfläche 12 der Mehrschichtanordnung 8, Thermisches Beaufschlagen der Spannungserzeugungsschicht 10 zum Erzeugen von mechanischen Spannungen innerhalb der Mehrschichtanordnung 8, wobei die Spannungen in dem durch den Spenderwafer 6 gebildeten Anteil der Mehrschichtanordnung 8 so groß werden, dass sich im Spenderwafer 6 ein Riss ausbildet, durch den der Spenderwafer 6 in einen Abtrennteil 14 und einen Verbindungsteil 16 gespalten wird, wobei der Verbindungsteil 16 am Bondwafer 2 verbleibt und wobei der abgespaltete Abtrennteil 14 eine größere Dicke aufweist als der Verbindungsteil 16.

Die vorliegende Erfindung bezieht sich somit auf ein Verfahren zur Herstellung eines Mehrkomponentenwafers, insbesondere eines MEMS-Wafers. In einer bevorzugten Ausführungsform umfasst das erfindungsgemäße Verfahren daher u.a. die Schritte: Bereitstellen eines Bondwafers 2, wobei zumindest ein Oberflächenanteil 4 des Bondwafers 2 durch eine Oxidschicht ausgebildet wird, Bereitstellen eines Spenderwafers 6, wobei der Spenderwafer 6 dicker ist als der Bondwafer 2, In Kontakt bringen des Spenderwafers 6 mit dem durch die Oxidschicht gebildeten Oberflächenanteil 4 des Bondwafers 2, Bilden einer Mehrschichtanordnung 8 durch Verbinden des Spenderwafers 6 und des Bondwafers 2 im Bereich des Kontakts, Erzeugen von Modifikationen 18 im Inneren des Spenderwafers 6 zum Vorgeben eines Ablösebereichs 11 zum Trennen der Mehrschichtanordnung 8 in einen Abtrennteil 14 und einen Verbindungsteil 16 mittels einem Laser-Strahl, wobei die Erzeugung der Modifikationen 18 vor Bildung der Mehrschichtanordnung 8 erfolgt, Trennen der Mehrschichtanordnung entlang dem Ablösebereich infolge einer durch die Erzeugung einer ausreichenden Anzahl an Modifikationen bewirkten Schwächung der Mehrschichtanordnung oder infolge einer Erzeugung von mechanischen Spannungen in der Mehrschichtanordnung, wobei der Verbindungsteil 16 am Bondwafer 2 verbleibt und wobei der abgespaltete Abtrennteil 14 eine größere Dicke aufweist als der Verbindungsteil 16.

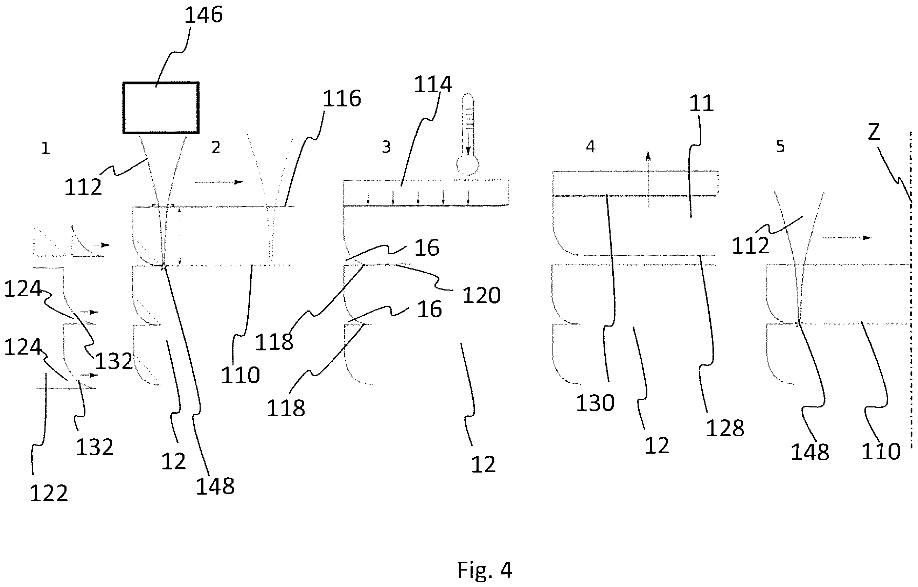

Fig. 4 zeigt 5 Darstellungen, durch die Beispiele für die erfindungsgemäße Festkörperscheibenherstellung bzw. Waferherstellung gezeigt werden. Darstellung 1 zeigt dabei ein Schleifwerkzeug 122, das zwei zueinander beabstandete Bearbeitungsanteile 24 aufweist, die jeweils eine Hauptschleiffläche 132 ausbilden. Die Hauptschleifflächen 132 sind dabei so ausgebildet, dass sie in einem Spendersubstrat 12 Vertiefungen 16 erzeugen. Das Schleifwerkzeug 122 ist bevorzugt als Rotationsschleifwerkzeug oder als Bandschleifwerkzeug ausgebildet.

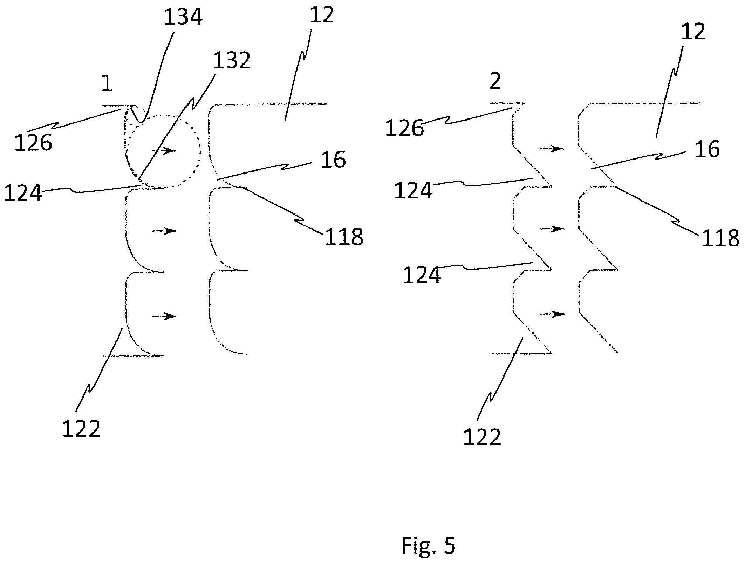

Darstellung 2 der Fig. 4 zeigt ein Spendersubstrat 12, in dem mittels des Schleifwerkzeugs 122 Vertiefungen 16 erzeugt wurden. Die Vertiefungen 16 sind dabei in Längsrichtung des Spenderwafers 12 bevorzugt gleichmäßig zueinander beabstandet, wobei auch denkbar, ist, dass die Abstände unterschiedlich groß sind. Gemäß der zweiten Darstellung in Fig. 5 werden ferner mittels einer LASER-Einrichtung 146 Modifikationen 110 im Spendersubstrat 12 erzeugt. Die LASER-Einrichtung 146 emittiert dazu LASER-Strahlen 112, die über eine bevorzugt ebene Oberfläche 116 des Spendersubstrats 12 in das Spendersubstrat 12 eindringen und an einem Fokuspunkt 148, insbesondere durch eine Mehrphotonenanregung, eine Modifikation 110 der Gitterstruktur des Festkörpers bzw. des Spendersubstrats 12 erzeugt bzw. bewirkt. Die Modifikation 110 stellt hierbei bevorzugt eine Materialumwandlung, insbesondere eine Überführung des Materials in eine andere Phase, oder eine Materialzerstörung dar.

Die dritte Darstellung zeigt, dass eine Spannungserzeugungsschicht 114 an der Oberfläche 116, über welche die LASER-Strahlen 112 zum Erzeugen der Modifikationen 110 in das Spendersubstrat 12 eingeleitet wurden, erzeugt oder angeordnet wurde. Die Spannungserzeugungsschicht 114 wird zum Erzeugen von mechanischen Spannungen im Spendersubstrat 12 thermisch beaufschlagt bzw. temperiert, insbesondere abgekühlt. Durch das thermische Beaufschlagen der Spannungserzeugungsschicht 114, zieht sich die Spannungserzeugungsschicht 114 zusammen, wodurch sich die mechanischen Spannungen in dem Spendersubstrat 12 ergeben. Die zuvor erzeugten Vertiefungen 16 bilden dabei Kerben aus, durch welche die mechanischen Spannungen derart geleitet werden können, dass sich der durch die Spannungen ergebende Riss 120 gezielt in dem durch die Modifikationen 110 vorgegebenen Rissführungsbereich ausbreitet. Die Vertiefungsenden 118 grenzen daher bevorzugt an dem jeweiligen durch die Modifikationen 110 vorgegebenen Rissführungsbereich an. Bevorzugt wird immer nur genau die Festkörperschicht 11 abgespaltet, deren Vertiefung 16 am wenigsten zur Spannungserzeugungsschicht 114 beabstandet ist.

Die Darstellung 4 zeigt einen Zustand, nach erfolgter Rissausbreitung. Die Festkörperscheibe 11 ist von dem Spendersubstrat 12 abgespalten und die Spannungserzeugungsschicht 114 verbleibt zunächst weiterhin an der Oberfläche 116 der Festkörperscheibe 11.

Das Bezugszeichen 128 kennzeichnet, welche Seite der Festkörperscheibe 11 hier als Unterseite der Festkörperscheibe 11 bezeichnet ist und das Bezugszeichen 130 kennzeichnet, welche Seite der Festkörperscheibe 11 hier als Oberseite der Festkörperscheibe 11 bezeichnet ist.

Die Darstellung 5 zeigt ein Verfahren, bei dem ohne eine Spannungserzeugungsschicht 114 eine Ablösung der Festkörperschicht 11 vom Spendersubstrat 12 bewirkt wird. Es werden hierbei bevorzugt nach der Erzeugung der Vertiefung 16 so viele Modifikationen 110 mittels LASER-Strahlen 112 erzeugt, dass sich die Festkörperschicht 11 vom Spendersubstrat 12 ablöst. Die gestrichelte Linie Z kennzeichnet hierbei bevorzugt ein Zentrum bzw. eine Rotationsachse des Spendersubstrats 12. Das Spendersubstrat 12 ist bevorzugt um die Rotationsachse Z rotierbar.

Fig. 5 zeigt zwei Darstellungen, wobei jede Darstellung ein Schleifwerkzeug 122 mit einer bestimmten Kontur zeigt. Wird in Bezug auf das Schleifwerkzeug von einem ebenen, geraden oder gebogenen Anteil gesprochen, dann ist damit immer ein Anteil der gezeigten Kontur zu verstehen. Selbstverständlich kann das Schleifwerkzeug 122 z.B. als ein Rotationsschleifwerkezeug ausgebildet sein, wodurch sich die an die Kontur in Umfangsrichtung anschließenden Anteile in Umfangsrichtung bevorzugt gebogen erstrecken würden. Das in der ersten Darstellung der Fig. 5 gezeigte Schleifwerkzeug 122 weist einen ersten Bearbeitungsanteil 124 auf, der eine gebogene Hauptschleiffläche 132 aufweist, und weist einen zweiten Bearbeitungsanteil 126 auf, der eine gebogene Nebenschleiffläche 134 aufweist, wobei der Radius der Hauptschleiffläche 132 größer ist als der Radius der Nebenschleiffläche 134, bevorzugt ist der Radius der Hauptschleiffläche 132 mindestens doppelt, dreifach, vierfach oder fünffach so groß, wie der Radius der Nebenschleiffläche 134.

Gemäß der zweiten Darstellung der Fig. 5 weist der erste Bearbeitungsanteil 124 des Schleifwerkzeugs 122 eine gerade Hauptschleiffläche 132 auf und der zweite Bearbeitungsanteil 126 weist eine gerade Nebenschleiffläche 134 auf, wobei mittels der Hauptschleiffläche 132 mehr Material als mit der Nebenschleiffläche 134 von dem Spendersubstrat 12 entfernt wird.

Die in Fig. 5 gezeigten Schleifwerkzeuge 122 und die durch die gezeigten Schleifwerkezeuge 122 erzeugten Vertiefungen, können ebenfalls hinsichtlich den in Fig. 4 gezeigten Darstellungen verwendet werden.

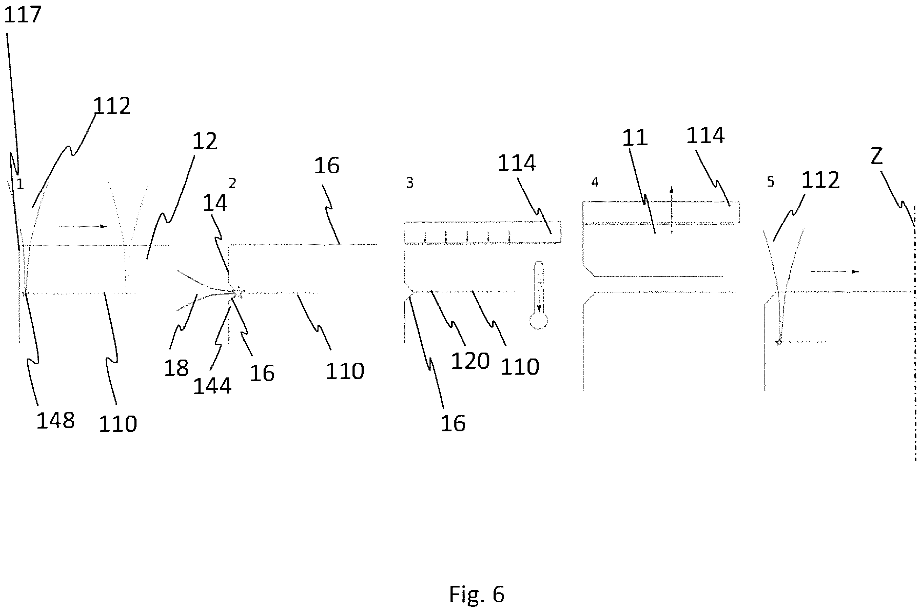

Fig. 6 zeigt eine weitere Variante des erfindungsgemäßen Verfahrens. Es kann durch einen Vergleich der ersten und der fünften Darstellung erkannt werden, dass die mittels den LASER-Strahlen 112 erzeugten Modifikationen 110 im Falle einer ebenen Oberfläche 116 näher zum Rand 144 hin erzeugt werden können, als wenn die Kante 117 der Oberfläche 116 entfernt ist, wie dies in der fünften Darstellung gezeigt ist. Die LASER-Strahlen 112 dringen hierbei analog zur bzgl. Fig. 4 erläuterten Modifikationserzeugung in das Spendersubstrat 12 ein.

Die zweite Darstellung der Fig. 6 zeigt die Erzeugung einer Vertiefung 16 ausgehend von einer umlaufenden Oberfläche 14 in Richtung Zentrum Z des Spendersubstrats 12, wobei die Vertiefung mittels Ablations-LASER-Strahlen 18 eines Ablations-LASERS (nicht gezeigt) erzeugt wird. Bevorzugt verdampfen die Ablations-LASER-Strahlen 18 hierbei zum Erzeugen der Vertiefung 16 das Material des Spendersubstrats 12.

Darstellung 3 der Fig. 6 entspricht im Wesentlichen der Darstellung 3 der Fig. 5, wobei lediglich die Form der Vertiefung hierbei nicht unsymmetrisch, sondern symmetrisch erzeugt ist. Somit wird ebenfalls gemäß dieser Darstellung eine Spannungserzeugungsschicht 114 an dem Spendersubstrat 12 erzeugt oder angeordnet und zum Erzeugen von mechanischen Spannungen zum Auslösen eines Risses 120 thermisch beaufschlagt, insbesondere mittels flüssigem Stickstoff.

Darstellung 4 der Fig. 6 zeigt die vom Spendersubstrat 12 abgespaltete Festkörperscheibe 11, an der weiterhin die Spannungserzeugungsschicht angeordnet ist.

Der Darstellung 5 der Fig. 6 lässt sich weiter entnehmen, dass bei einem Spendersubstrat 12 dessen Kante 117 bearbeitet ist, die mittels Ablations-LASER-Strahlen 18 zu erzeugende Vertiefung 16 weiter in Richtung Zentrum des Spendersubstrats 12 hineinreichen muss, als wenn die Kante 117 nicht bearbeitet ist. Es ist hierbei jedoch ebenfalls vorstellbar, dass die Vertiefung nicht mittels Ablations-LASER-Strahlen 18, sondern mittels eines Schleifwerkzeugs 122 (wie es z.B. aus dem Figuren 4 und 5 bekannt ist) erzeugt wird.

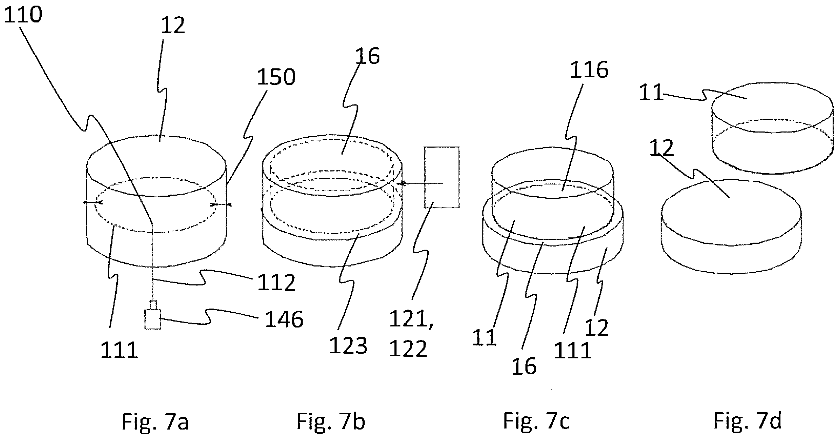

Fig. 7a zeigt eine erfindungsgemäße zusätzliche oder alternative Lösung zum Abtrennen von Festkörperschichten 11 oder Festkörperlagen 11 von einem Spendersubstrat 12. Gemäß Fig. 7a erfolgt die Erzeugung eines Ablösebereichs 111 im inneren des Spendersubstrats 2. Die Modifikationen 110 sind dabei bevorzugt zu einer umlaufenden Begrenzungsfläche 150 des Spendersubstrats 12 beabstandet. Bevorzugt werden die Modifikationen 110 analog zur Darstellung 2 der Fig. 4 erzeugt. Es ist hierbei denkbar, dass die LASER-Strahlen 112 von unten oder von oben, d.h. über die Oberfläche 116 in das Spendersubstrat 12 eingeleitet werden.

Fig. 7b zeigt schematisch die Bearbeitung des Spendersubstrats 12 mittels eines Ablationswerkezug 122, insbesondere einem Werkzeug zum spanenden Bearbeiten des Spendersubstrats 12, wie einem Schleifwerkzeug 122. Durch die Bearbeitung wird zumindest abschnittsweise in Umfangsrichtung des Spendersubstrats 12 Material im gesamten Bereich zwischen dem Ablösebereich und einer zum Ablösebereich bevorzugt homogen, insbesondere parallel, beabstandeten Oberfläche des Spendersubstrats 12 zur Reduzierung der radialen Erstreckung des Spendersubstrats 12 abgetragen. Bevorzugt wird das Material ringförmigt, insbesondere mit einer konstanten oder im Wesentlichen konstanten radialen Ausdehnung, entfernt.

Fig. 7c zeigt ein Beispiel für einen Zustand nach dem Abtrag des Materials. Es ist hierbei z.B. denkbar, dass das Material in axialer Richtung des Spendersubstrats 12 bis auf die Ablöseebene oder darunter oder darüber abgetragen wird.

Fig. 7d zeigt einen Zustand nach dem Abtrennen bzw. Ablösen der Festkörperlage 11 von dem Spendersubstrat 12.

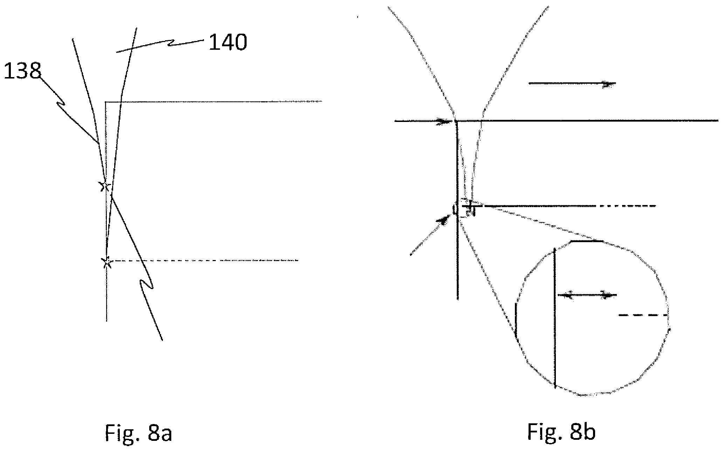

Die Figuren 8a und 8b zeigen ein bei der Erzeugung von Modifikationen mittels LASER-Strahlen 112 auftretendes Problem im Randbereich des Spendersubstrats 12. Durch die unterschiedlichen Brechindizes in der Luft und im Spendersubstrat treffen die LASER-Strahlanteile 138, 140 eines LASER-Strahls 112 nicht genau zusammen, wodurch ungewünschte Effekte, wie die Erzeugung von Defekten an ungewünschten Orten, eine ungewünschte lokale Aufheizung oder ein Verhinderung einer Modifikationserzeugung.

Fig. 8b zeigt, dass eine problemlose Erzeugung von Modifikationen 110 erst erfolgen kann, wenn die zu erzeugende Modifikation 110 soweit von der umlaufenden Oberfläche des Spendersubstrats 12 entfernt ist, dass beide LASER-Strahlanteile 138, 140 jeweils durch Material mit demselben Brechungsindex und bevorzugt über die gleiche Weglänge gebrochen werden. Dies führt jedoch dazu, dass die Modifikationserzeugung, wie sie im zum Randbereich beabstandeten Bereich erfolgt, nicht ohne weiteres auf den Randbereich erstreckt werden kann.

Die vorliegende Erfindung bezieht sich somit auch auf ein Verfahren zum Abtrennen von Festkörperscheiben 11 von einem Spendersubstrat 12. In einer bevorzugten Ausführungsform umfasst das erfindungsgemäße Verfahren dabei u.a. die Schritte: Bereitstellen eines Spendersubstrats 12, Abtragen von Material des Spendersubstrats12 ausgehend von einer sich in Umfangsrichtung des Spendersubstrats 2 erstreckenden Oberfläche 14 in Richtung Zentrum Z des Spendersubstrats 12 zum Erzeugen einer Vertiefung 16, wobei das Material mittels Ablations-LASER-Strahlen 18 entfernt wird und/oder die Vertiefung 16 asymmetrisch erzeugt wird, Erzeugen von Modifikationen 110 im Inneren des Spendersubstrats 12 mittels weiterer LASER-Strahlen 112, wobei die Modifikationen 10 derart positioniert werden, dass sie sich an die Vertiefung 16 anschließen, wobei sich die Festkörperscheibe 11 durch die erzeugten Modifikationen 110 von dem Spendersubstrat 12 ablöst oder eine Spannungserzeugungsschicht 114 an einer zur umlaufenden Oberfläche geneigt ausgerichteten, insbesondere ebenen, Oberfläche 116 des Spendersubstrats 12 erzeugt oder angeordnet wird und durch ein thermisches Beaufschlagen der Spannungserzeugungsschicht 114 mechanische Spannungen in dem Spendersubstrat 12 erzeugt werden, wobei durch die mechanischen Spannungen ein Riss 120 zum Abtrennen einer Festkörperschicht 11 entsteht, der sich ausgehend von der Vertiefung 16 entlang der Modifikationen 110 ausbreitet.

Die vorliegende Erfindung bezieht sich somit auch auf ein Verfahren zum Abtrennen von Festkörperscheiben 11 von einem Spendersubstrat 12. In einer bevorzugten Ausführungsform umfasst das erfindungsgemäße Verfahren dabei u.a. die Schritte: Erzeugen von Modifikationen 110 im Inneren des Spendersubstrats 12 mittels LASER-Strahlen 112, wobei durch die Modifikationen 110 ein Ablösebereich vorgegeben wird, entlang dem eine Abtrennung der Festkörperlag 11 von dem Spendersubstrat 12 bzw. der Mehrschichtanordnung erfolgt,

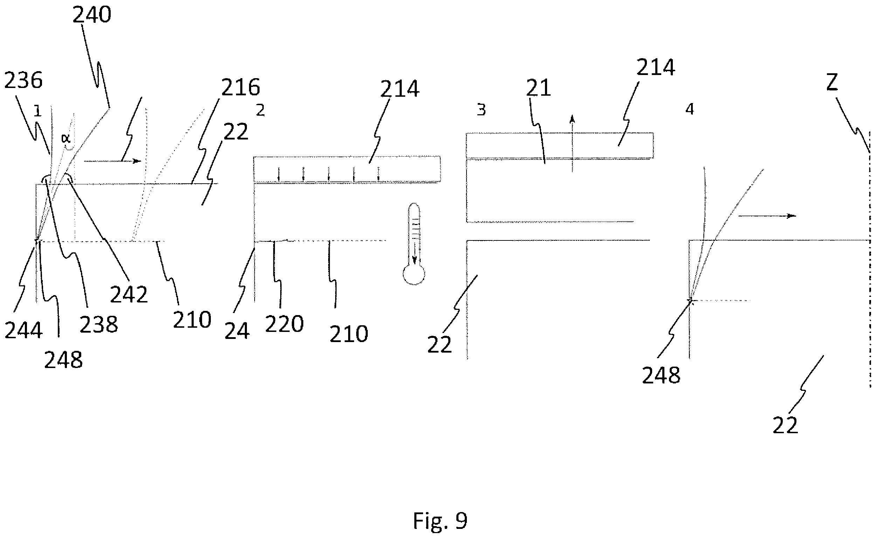

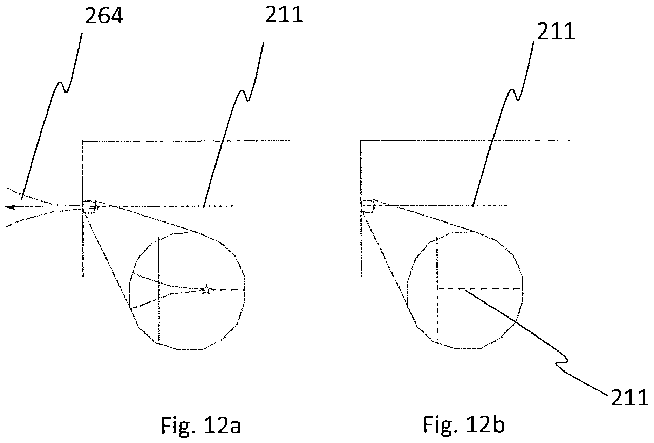

Abtragen von Material des Spendersubstrats 12 ausgehend von einer sich in Umfangsrichtung des Spendersubstrats 12 erstreckenden Oberfläche 14 in Richtung Zentrum Z des Spendersubstrats 12, insbesondere zum Erzeugen einer umlaufenden Vertiefung 16, wobei durch den Materialabtrag der Ablösebereich freigelegt wird, Abtrennen der Festkörperlage von dem Spendersubstrat, wobei das Spendersubstrat im Ablösebereich durch die Modifikationen derart geschwächt wird, dass sich die Festkörperlage 11 infolge des Materialabtrags von dem Spendersubstrat 12 ablöst oder nach dem Materialabtrag eine solche Anzahl an Modifikationen erzeugt wird, dass das Spendersubstrat im Ablösebereich derart geschwächt wird, dass sich die Festkörperlage 11 von dem Spendersubstrat 12 ablöst oder eine Spannungserzeugungsschicht 114 an einer zur umlaufenden Oberfläche geneigt ausgerichteten, insbesondere ebenen, Oberfläche 16 des Spendersubstrats 12 erzeugt oder angeordnet wird und durch ein thermisches Beaufschlagen der Spannungserzeugungsschicht 114 mechanische Spannungen in dem Spendersubstrat 12 erzeugt werden, wobei durch die mechanischen Spannungen ein Riss 120 zum Abtrennen einer Festkörperlage 11 entsteht, der sich ausgehend von der durch den Materialabtrag freigelegten Oberfläche des Spendersubstrats entlang der Modifikationen 110 ausbreitet. Fig. 9 zeigt 4 Darstellungen. In der ersten Darstellung der Fig. 9 ist ein Spendersubstrat 22 gezeigt, dass mit LASER-Strahlen 212 beaufschlagt wird. Die LASER-Strahlen 212 sind in ihrer Gesamtheit derart gegenüber der Oberfläche 216, über die die LASER-Strahlen in das Spendersubstrat 22 eindringen, geneigt, dass die Neigung von einem 90° Winkel abweicht. Bevorzugt ist ein erster Anteil 236 an LASER-Strahlen 212 gegenüber der Oberfläche 216 in einem ersten Winkel 238 orientiert und ein weiterer Anteil 240 an LASER-Strahlen 212 ist gegenüber der Oberfläche 216 in einem zweiten Winkel 242 orientiert. Die LASER-Strahlanteile 236 und 240 sind bevorzugt zur Erzeugung aller zur Abtrennung einer bestimmten Festkörperschicht 21 erzeugten Modifikationen 212 gegenüber der Oberfläche 216, über die die LASER-Strahlenanteile 236, 240 in das Spendersubstrat 22 eindringen, bevorzugt stets identisch geneigt. Es kann der ersten Darstellung der Fig. 12 ferner entnommen werden, dass der Fokuspunkt 248 zum Erzeugen von Modifikationen 210 aufgrund der geneigten LASER-Strahlanteile 236, 240 in dem Spendersubstrat 22 bis zum Rand 244 oder unmittelbar bis zum Rand 244 geführt werden kann.

Der Darstellung 2 der Fig. 9 lässt sich ferner entnehmen, dass gemäß der geneigt ausgerichteten LASER-Strahlanteile 236, 240 eine materialabtragende Behandlung des Rands 244 des Spendersubstrats 22 nicht oder nur deutlich reduziert erforderlich ist. Die an der Oberfläche 216 angeordnete oder erzeugte Spannungserzeugungsschicht 214 bewirkt eine Erzeugung mechanischer Spannungen in dem Spendersubstrat 22, wodurch sich aufgrund der bis zum Rand 244 erzeugten Modifikationen 210 ein Riss 220 sehr präzise geführt vom Rand 244 in das Spendersubstrat 22 hineinausbreitet.

Der Darstellung 3 der Fig. 9 zeigt eine vollständig vom Spendersubstrat 22 abgespaltete Festkörperscheibe 21, wobei die Festkörperscheibe 21 gemäß dieser Ausführungsform bevorzugt keine Kantenbehandlung erfahren hat.

Darstellung 4 der Fig. 9 deutet an, dass ebenfalls durch das Erzeugen von Modifikationen 210 mittels LASER-Strahlen 236, 240 (ohne eine Spannungserzeugungsschicht 214) eine Festkörperscheibe 21 von dem Spendersubstrat 22 entfernbar ist.

Die vorliegende Erfindung bezieht sich somit auch auf ein Verfahren zum Abtrennen von Festkörperscheiben 21 von einem Spendersubstrat 22. In einer bevorzugten Ausführungsform umfasst das erfindungsgemäße Verfahren dabei u.a. die Schritte: Bereitstellen eines Spendersubstrats 22, Erzeugen von Modifikationen 210 im Inneren des Spendersubstrats 22 mittels LASER-Strahlen 212, wobei die LASER-Strahlen 212 über eine ebene Oberfläche 216 des Spendersubstrats 22 in das Spendersubstrat 22 eindringen, wobei die Gesamtheit der LASER-Strahlen 212 derart gegenüber der ebenen Oberfläche 216 des Spendersubstrats 22 geneigt ist, dass ein erster Anteil 236 der LASER-Strahlen 212 in einem ersten Winkel 238 zur ebenen Oberfläche 216 des Spendersubstrats 22 in das Spendersubstrat 22 eindringt und mindestens ein weiterer Anteil 240 der LASER-Strahlen 212 in einem zweiten Winkel 242 zur eben Oberfläche 216 des Spendersubstrats 22 in das Spendersubstrat 22 eindringt, wobei sich der Betrag des ersten Winkels 238 von dem Betrag des zweiten Winkels 242 unterscheidet, wobei der erste Anteil 236 der LASER-Strahlen 212 und der weitere Anteil 240 der LASER-Strahlen 212 zum Erzeugen der Modifikation 210 im Spendersubstrat 22 fokussiert werden, wobei sich die Festkörperscheibe 21 durch die erzeugten Modifikationen 210 von dem Spendersubstrat 22 ablöst oder eine Spannungserzeugungsschicht 214 an der ebenen Oberfläche 216 des Spendersubstrats 22 erzeugt oder angeordnet wird und durch ein thermisches Beaufschlagen der Spannungserzeugungsschicht 214 mechanische Spannungen in dem Spendersubstrat 22 erzeugt werden, wobei durch die mechanischen Spannungen ein Riss 220 zum Abtrennen einer Festkörperschicht 21 entsteht, der sich entlang der Modifikationen 210 ausbreitet.

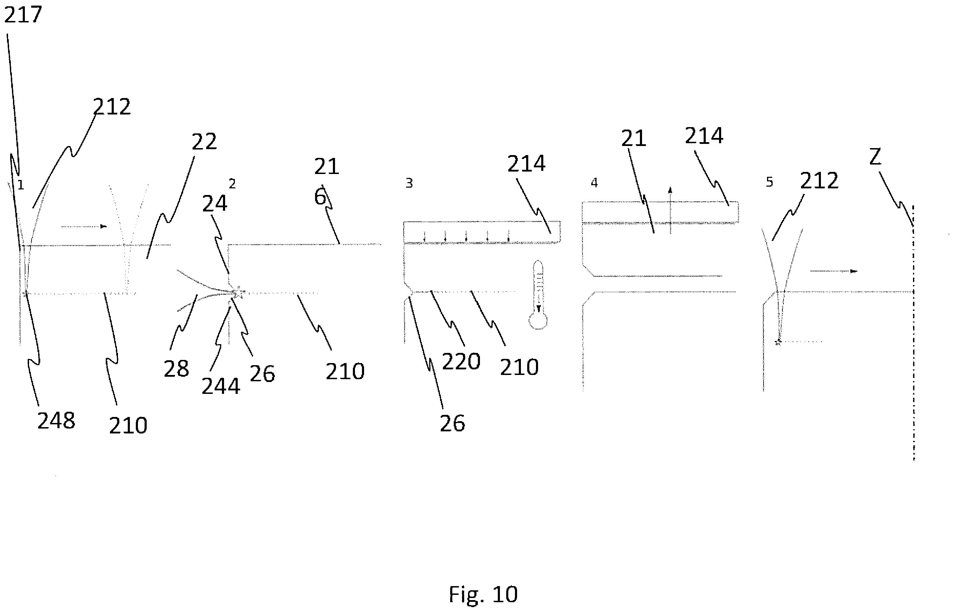

Fig. 10 zeigt eine weitere Variante des erfindungsgemäßen Verfahrens. Es kann durch einen Vergleich der ersten und der fünften Darstellung erkannt werden, dass die mittels den LASER-Strahlen 212 erzeugten Modifikationen 210 im Falle einer ebenen Oberfläche 216 näher zum Rand 244 hin erzeugt werden können, als wenn die Kante 217 der Oberfläche 216 entfernt ist, wie dies in der fünften Darstellung gezeigt ist. Die LASER-Strahlen 212 dringen hierbei analog zur bzgl. Fig. 9 erläuterten Modifikationserzeugung in das Spendersubstrat 22 ein.

Die zweite Darstellung der Fig. 10 zeigt die Erzeugung einer Vertiefung 26 ausgehend von einer umlaufenden Oberfläche 24 in Richtung Zentrum Z des Spendersubstrats 22, wobei die Vertiefung mittels Ablations-LASER-Strahlen 28 eines Ablations-LASERS (nicht gezeigt) erzeugt wird. Bevorzugt verdampfen die Ablations-LASER-Strahlen 28 hierbei zum Erzeugen der Vertiefung 26 das Material des Spendersubstrats 22.

Darstellung 3 der Fig. 10 entspricht im Wesentlichen der Darstellung 3 der Fig. 9, wobei lediglich die Form der Vertiefung hierbei nicht unsymmetrisch, sondern symmetrisch erzeugt ist. Somit wird ebenfalls gemäß dieser Darstellung eine Spannungserzeugungsschicht 214 an dem Spendersubstrat 22 erzeugt oder angeordnet und zum Erzeugen von mechanischen Spannungen zum Auslösen eines Risses 220 thermisch beaufschlagt, insbesondere mittels flüssigem Stickstoff.

Darstellung 4 der Fig. 10 zeigt die vom Spendersubstrat 2 abgespaltete Festkörperscheibe 21, an der weiterhin die Spannungserzeugungsschicht angeordnet ist.

Der Darstellung 5 der Fig. 10 lässt sich weiter entnehmen, dass bei einem Spendersubstrat 22 dessen Kante 217 bearbeitet ist, die mittels Ablations-LASER-Strahlen 28 zu erzeugende Vertiefung 26 weiter in Richtung Zentrum des Spendersubstrats 22 hineinreichen muss, als wenn die Kante 217 nicht bearbeitet ist. Es ist hierbei jedoch ebenfalls vorstellbar, dass die Vertiefung nicht mittels Ablations-LASER-Strahlen 28, sondern mittels eines Schleifwerkzeugs 222 (wie es z.B. aus der Figur 9 bekannt ist) erzeugt wird.

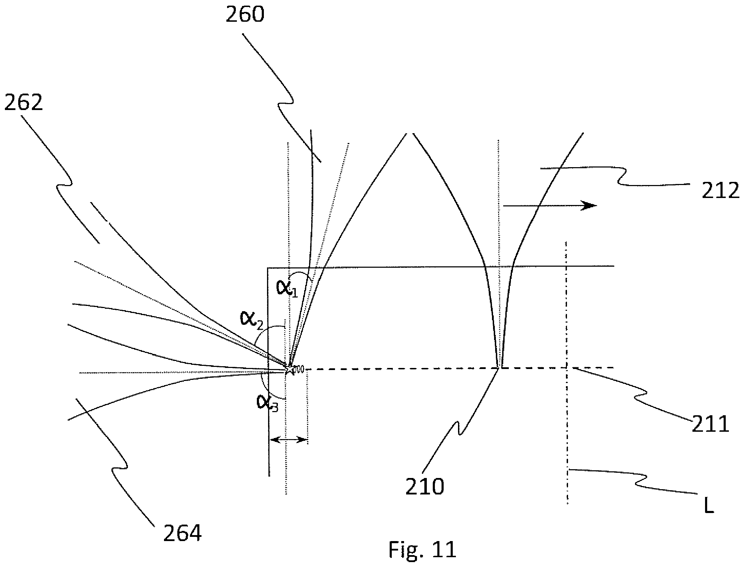

Fig. 11 zeigt eine Anordnung gemäß der ein LASER-Strahl 212 parallel zur Längsachse L ausgerichtet ist. Ferner zeigt diese Darstellung zusätzlich oder alternativ einen LASER-Strahl 260, der in einem Winkel α1 gegenüber der Längsachse L geneigt ist. Beide LASER-Strahlen 212 und 260 können hierbei zur Erzeugung der Modifikationen 210 dienen, durch die ein Ablösebereich 211 vorgegeben wird. Es ist hierbei denkbar, dass durch den gegenüber der Längsachse L ungeneigten LASER-Strahl 212 eine Mehrzahl der Modifikationen 210 erzeugt wird und im Randbereich, d.h. in einem Abstand von weniger als 10 mm, insbesondere von weniger als 5 mm oder von weniger als 2 mm oder von weniger als 1 mm oder von weniger als 0,5 mm zur umlaufenden Oberfläche (Umfangsoberfläche), die Modifikationen 210 durch den gegenüber der Längsachse L geneigten LASER-Strahl 260 erzeugt werden.

Alternativ ist ferner denkbar, dass alle Modifikationen 210 des Ablösebereichs oder die Mehrzahl der Modifikationen 210 des Ablösebereichs 211 durch den gegenüber der Längsachse L in einem Winkel α1 geneigten LASER-Strahl 260 erzeugt werden.

Zusätzlich oder alternativ können im Sinne der vorliegenden Erfindung die Modifikationen 210 im Randbereich durch einen weiteren gegenüber der Längsachse L des Spendersubstrats 22 geneigten LASER-Strahl 262, 264 erzeugt werden, wobei dieser LASER-Strahl bevorzugt über eine umlaufende Oberfläche des Spendersubstrats 22 in das Spendersubstrat 22 eindringt. Der Darstellung kann entnommen werden, dass ein LASER-Strahl 262 z.B. in einem Winkel α2, der größer als 0° und kleiner als 90° ist, gegenüber dem Ablösebereich 211 über die umlaufende Oberfläche in das Spendersubstrat 22 zur Erzeugung der Modifikationen 210 im Randbereich einleitbar ist. Ferner kann der Darstellung entnommen werden, dass ein LASER-Strahl 264 in der Erstreckungsrichtung des Ablösebereichs 211 über die umlaufende Oberfläche des Spendersubstrats 22 in das Spendersubstrat 22 zum Erzeugen der Modifikationen 210 einleitbar ist. Der LASER-Strahl 264 ist dabei bevorzugt in einem Winkel α3, zwischen 80° und 100°, insbesondere 90° oder im Wesentlichen 90°, gegenüber der Längsachse L des Spendersubstrats 22 geneigt.

Somit kann durch einen der LASER-Strahlen 260, 262, 264 eine Modifikationserzeugung 210 im Bereich des Randes erfolgen.

Weiterhin können erfindungsgemäß die Aussagen zu Fig. 9 analog auf die in Fig. 211 gezeigten Gegenstände angewendet oder übertragen werden und umgekehrt.

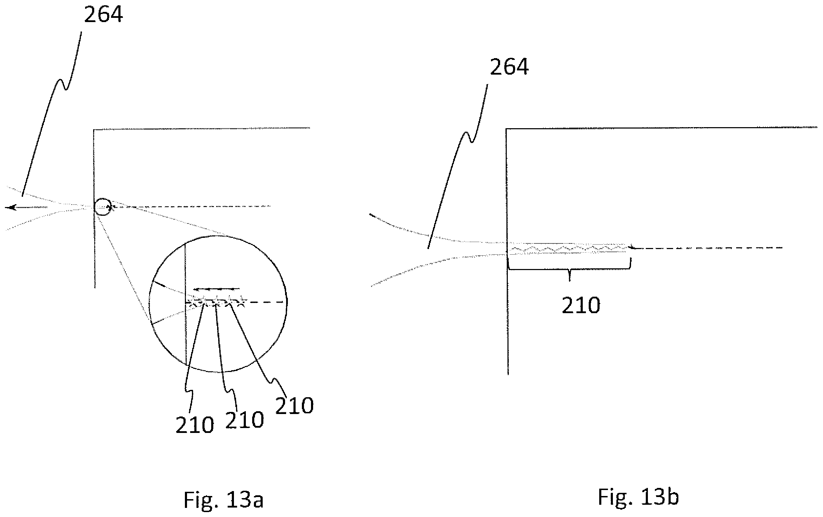

Fig. 13a zeigt einen bis auf den Randbereich erzeugten Ablösebereich 211. Ferner zeigt Fig. 13a die Modifikationserzeugung mittels eines LASER-Strahls 264. Durch den LASER-Strahl 264 werden bevorzugt in radialer Richtung mehrere Modifikationen 210, insbesondere auf einer Linie, mit größer werdenden Abständen zum Zentrum bzw. einer Rotationsachse (die sich bevorzugt orthogonal zur ebenen Oberfläche 216 des Spendersubstrats 22 erstreckt) des Spenderwafers 22 erzeugt.

Fig. 13b zeigt schematisch einen Zustand nach der Erzeugung der Modifikationen 210. Der Ablösebereich 211 ist gemäß dieser Darstellung in Form einer sich vollständig im Inneren des Spenderwafers 22 erstreckenden Modifikationslage ausgebildet.

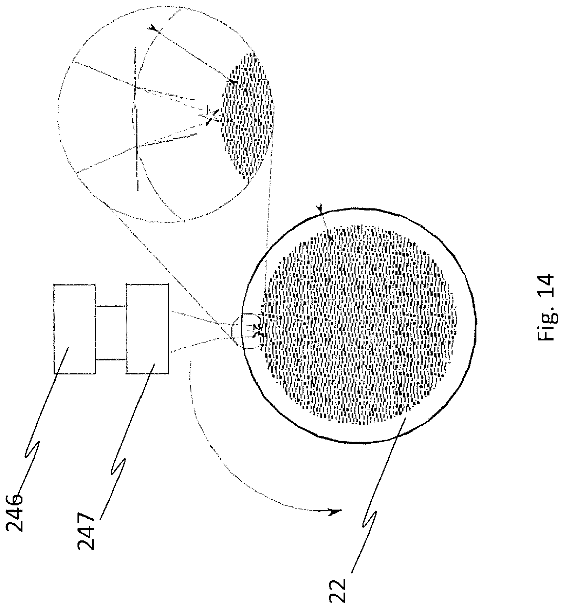

Die Figuren 14a und 14b zeigen zwei Varianten zur Erzeugung von Modifikationen 210 mittels über die umlaufende Oberfläche eingeleiteter LASER-Strahlen.

Gemäß Fig. 14a erfolgt die Erzeugung einer Vielzahl an Modifikationen 210 über dieselbe Eindringstelle, durch die die LASER-Strahlen 264 in das Spendersubstrat 22 eindringen. Die LASER-Strahlen werden zur Erzeugung der Modifikationen 210 auf unterschiedliche Tiefen in radialer Richtung in das Spendersubstrat 22 fokussiert. Bevorzugt werden die Modifikationen 210 mit abnehmender Eindringtiefe der LASER-Strahlen bzw. mit kürzer werdendem Abstand des Fokuspunkts zur Eindringstelle erzeugt.

Fig. 14b zeigt die filamentartige Modifikationserzeugung. Die in Form von Filamenten erzeugten Modifikationen 210 sind dabei länger als ein Vielfaches, insbesondere z.B. das 10 fache, 20 fache oder 50 fache, ihrer Querschnittserstreckung.

Fig. 15 zeigt eine LASER-Einrichtung 246, ein Aberrationsmittel 247 und eine Schnittdarstellung eines Spendersubstrats 2. Die Detaildarstellung der Fig. 15 zeigt den über die gebogene umlaufende Oberfläche des Spenderwafers 22 in den Spenderwafer 22 eindringenden LASER-Strahl 212, wobei durch die gestrichelt dargestellten Linien der mittels des Aberrationsmittels 247 angepasste Strahlungsverlauf dargestellt ist.

Die vorliegende Erfindung bezieht sich somit auch auf ein Verfahren zum Abtrennen von Festkörperscheiben 21 von einem Spendersubstrat 22. In einer bevorzugten Ausführungsform umfasst das erfindungsgemäße Verfahren dabei u.a. die Schritte: Bereitstellen eines Spendersubstrats 22, Erzeugen von mindestens einer Modifikationen 10 im Inneren des Spendersubstrats 22 mittels mindestens eines LASER-Strahls 212, wobei der LASER-Strahl 212 über eine ebene Oberfläche 216 des Spendersubstrats 22 in das Spendersubstrat 22 eindringt, wobei der LASER-Strahl 212 derart gegenüber der ebenen Oberfläche 216 des Spendersubstrats 22 geneigt ist, dass er in einem Winkel von ungleich 0° oder 180° gegenüber der Längsachse des Spendersubstrates in das Spendersubstrat eindringt, wobei der LASER-Strahl 212 zum Erzeugen der Modifikation 210 im Spendersubstrat 22 fokussiert wird, wobei sich die Festkörperscheibe 21 durch die erzeugten Modifikationen 210 von dem Spendersubstrat 22 ablöst oder eine Spannungserzeugungsschicht 214 an der ebenen Oberfläche 216 des Spendersubstrats 22 erzeugt oder angeordnet wird und durch ein thermisches Beaufschlagen der Spannungserzeugungsschicht 214 mechanische Spannungen in dem Spendersubstrat 22 erzeugt werden, wobei durch die mechanischen Spannungen ein Riss 220 zum Abtrennen einer Festkörperschicht 21 entsteht, der sich entlang der Modifikationen 210 ausbreitet.

## Patentansprüche

1. Verfahren zur Herstellung eines Mehrkomponentenwafers (1), insbesondere eines MEMS-Wafers, mindestens umfassend die Schritte:
Bereitstellen eines Bondwafers (2), wobei zumindest ein Oberflächenanteil (4) des Bondwafers (2) durch eine Oxidschicht ausgebildet wird,
Bereitstellen eines Spenderwafers (6), wobei der Spenderwafer (6) dicker ist als der Bondwafer (2),
In Kontakt bringen des Spenderwafers (6) mit dem durch die Oxidschicht gebildeten Oberflächenanteil (4) des Bondwafers (2),
Bilden einer Mehrschichtanordnung (8) durch Verbinden des Spenderwafers (6) und des Bondwafers (2) im Bereich des Kontakts,
Erzeugen von Modifikationen (18) im Inneren des Spenderwafers (6) zum Vorgeben eines Ablösebereichs (11) zum Trennen des Spenderwafers (6) in einen Abtrennteil (14) und einen Verbindungsteil (16) mittels mindestens einem LASER-Strahl,
wobei die Erzeugung der Modifikationen (18) vor Bildung der Mehrschichtanordnung (8) erfolgt,
und
wobei die LASER-Strahlen (20) über eine Oberfläche des Spenderwafers (6) in den Spenderwafer (6) eindringen, wobei diese Oberfläche des Spenderwafers (6) nach dem Teilen des Spenderwafers (6) Bestandteil des Verbindungsteils (16) ist,
Trennen der Mehrschichtanordnung entlang dem Ablösebereich
infolge einer durch die Erzeugung einer ausreichenden Anzahl an Modifikationen bewirkten Schwächung der Mehrschichtanordnung oder
infolge einer Erzeugung von mechanischen Spannungen in der Mehrschichtanordnung,
wobei der Verbindungsteil (16) am Bondwafer (2) verbleibt und
wobei der abgespaltete Abtrennteil (14) eine größere Dicke aufweist als der Verbindungsteil (16)
ferner umfassend die Schritte:
Umwandeln des Abtrennteils (14) durch eine Behandlung zumindest eines Oberflächenanteils des Abtrennteils (14) in einen weiteren Bondwafer (3) und
Bereitstellen des weiteren Bondwafers (3) zum in Kontakt bringen mit einem weiteren Spenderwafer.

2. Verfahren nach Anspruch 1,
**dadurch gekennzeichnet, dass**
die Behandlung einen Oxidationsprozess, insbesondere einen SiOx-Prozess, umfasst, wodurch eine Oxidation des mindestens einen Oberflächenanteils bewirkt wird.

3. Verfahren nach einem der vorangegangenen Ansprüche,
**dadurch gekennzeichnet, dass**
der Spenderwafer (6) eine erste Dicke D1 hat,
der Bondwafer (2) eine zweite Dicke D2 hat,
der Abtrennteil (14) eine dritte Dicke D3 hat, und
der Verbindungsteil (16) eine vierte Dicke D4 hat,
wobei die Dicke D1 größer ist als die Summe der Dicken D3 und D4,
wobei die Summe der Dicken D3 und D4 größer ist als die Dicke D3,
wobei die Dicke D3 um eine Dicke DL größer ist als die Dicke D2.

4. Verfahren nach Anspruch 3
**dadurch gekennzeichnet, dass**
die Dicke DL weniger als 200µm, insbesondere weniger als 100µm, beträgt und infolge von Polier- und/oder Ätzschritten entfernt wird.

5. Verfahren nach einem der vorangegangenen Ansprüche,
**dadurch gekennzeichnet**, dassi die LASER-Strahlen (20) von einer LASER-Einrichtung (22) emittiert werden,
wobei die LASER-Einrichtung (22) bevorzugt ein Picosekundenlaser oder ein Femtosekundenlaser ist
oder
wobei die Modifikationen (18) lokale Risse im Kristallgitter und/oder in eine andere Phase überführte Materialanteile im Inneren des Spenderwafers (6) sind.

6. Verfahren nach Anspruch 5,
**dadurch gekennzeichnet, dass**
die Energie der LASER-Strahlen (20) des fs-LASER derart gewählt wird, dass die Schädigungsausbreitung einer jeden Modifikation (18) in dem Spendersubstrat kleiner als 3 mal die Rayleighlänge, bevorzugt kleiner als die Rayleighlänge und besonders bevorzugt kleiner ein Drittel mal die Rayleighlänge ist
und/oder
die Wellenlänge der LASER-Strahlen (20) des fs-LASER derart gewählt wird, dass die Absorption des Spendersubstrats (6) kleiner als 10cm⁻¹ und bevorzugt kleiner als 1cm⁻¹ und besonders bevorzugt kleiner als 0,1cm⁻¹ ist
und/oder
sich die einzelnen Modifikationen (18) jeweils in Folge einer von dem fs-LASER bewirkten multi-photonen Anregung ergeben.

7. Verfahren nach Anspruch 5 oder Anspruch 6,
**dadurch gekennzeichnet, dass**
die LASER-Strahlen (20) zum Erzeugen der Modifikationen (18) über eine Oberfläche in den Spenderwafer (6) eindringen, die Bestandteil des Verbindungsteils (16) ist.

8. Verfahren nach einem der vorangegangenen Ansprüche,
ferner umfassend den Schritt:
Abtragen von Material der Mehrschichtanordnung ausgehend von einer sich in Umfangsrichtung der Mehrschichtanordnung erstreckenden Oberfläche (14) in Richtung Zentrum (Z) der Mehrschichtanordnung, insbesondere zum Erzeugen einer umlaufenden Vertiefung (16),
wobei durch den Materialabtrag der Ablösebereich freigelegt wird,
Abtrennen der Festkörperlage von der Mehrschichtanordnung,
wobei die Mehrschichtanordnung im Ablösebereich durch die Modifikationen derart geschwächt wird, dass sich die Festkörperlage (11) infolge des Materialabtrags von der Mehrschichtanordnung ablöst
oder
nach dem Materialabtrag eine solche Anzahl an Modifikationen erzeugt wird, dass das Spendersubstrat im Ablösebereich derart geschwächt wird, dass sich die Festkörperlage (11) von dem Spendersubstrat (12) ablöst oder
eine Spannungserzeugungsschicht (114) an einer zur umlaufenden Oberfläche geneigt ausgerichteten, insbesondere ebenen, Oberfläche (116) des Spendersubstrats (12) erzeugt oder angeordnet wird und durch ein thermisches Beaufschlagen der Spannungserzeugungsschicht (114) mechanische Spannungen in dem Spendersubstrat (12) erzeugt werden, wobei durch die mechanischen Spannungen ein Riss (120) zum Abtrennen einer Festkörperlage (11) entsteht, der sich ausgehend von der durch den Materialabtrag freigelegten Oberfläche des Spendersubstrats entlang der Modifikationen (110) ausbreitet.

9. Verfahren nach Anspruch 8,
**dadurch gekennzeichnet, dass**
der durch die Modifikationen (110) vorgegebene Ablösebereich vor dem Materialabtrag weiter zur umlaufenden Oberfläche des Spendersubstrats (12) beabstandet ist als nach dem Materialabtrag
oder
die Modifikationen (110) zum Vorgeben des Ablösebereichs vor dem Materialabtrag erzeugt werden und durch den Materialabtrag zumindest stellenweise eine Reduzierung des Abstands des Ablösebereichs auf weniger als 10mm, insbesondere auf weniger als 5mm und bevorzugt auf weniger als 1mm, erreicht wird oder
die Modifikationen zum Vorgeben des Ablösebereichs nach dem Materialabtrag erzeugt werden, wobei die Modifikationen (110) derart erzeugt werden, dass der Ablösebereich zumindest stellenweise weniger als 10mm, insbesondere weniger als 5mm und bevorzugt weniger als 1mm, zu einer durch den Materialabtrag freigelegten Oberfläche beabstandet ist
oder
das Material mittels Ablations- Strahlen (8), insbesondere Ablations-LASER-Strahlen, oder Ablations-Fluiden entfernt wird
oder
durch den Materialabtrag eine Vertiefung (6) mit einer asymmetrischen Gestalt erzeugt wird,
oder
der Materialabtrag zumindest abschnittsweise in Umfangsrichtung des Spendersubstrats (12) im gesamten Bereich zwischen dem Ablösebereich und einer zum Ablösebereich homogen beabstandeten Oberfläche des Spendersubstrats (12) als eine Reduzierung des radialen Erstreckung des Spendersubstrats (12) erfolgt
oder
die Vertiefung (16) das Spendersubstrat (12) vollständig in Umfangsrichtung umgibt
oder
die Vertiefung (16) in Richtung Zentrum (Z) bis zu einem Vertiefungsende (118) hin enger werdend, insbesondere keilförmig, verläuft, wobei das Vertiefungsende (118) in der Ebene liegt, in der sich der Riss (120) ausbreitet
oder
die asymmetrische Vertiefung (16) mittels einem zur Vertiefung (16) zumindest abschnittsweise negativ geformten Schleifwerkzeug (122) erzeugt wird
oder
das Schleifwerkzeug (122) mindestens zwei verschieden geformte Bearbeitungsanteile (124, 126) aufweist, wobei ein erster Bearbeitungsanteil (124) zum Bearbeiten des Spendersubstrats (12) im Bereich der Unterseite (128) einer abzutrennenden Festkörperscheibe (11) und ein zweiter Bearbeitungsanteil (126) zum Bearbeiten des Spendersubstrats (12) im Bereich der Oberseite (130) der von dem Spendersubstrat (12) abzutrennenden Festkörperscheibe (11) bestimmt ist
oder
der erste Bearbeitungsanteil (124) eine tiefere oder volumenmäßig größere Vertiefung (16) in dem Spendersubstrat (12) erzeugt als der zweite Bearbeitungsanteil (126), wobei der erste Bearbeitungsanteil (124) und/oder der zweite Bearbeitungsanteil (126) gebogene oder gerade Schleifflächen (132, 134) aufweisen
oder
der erste Bearbeitungsanteil (124) eine gebogene Hauptschleiffläche (132) aufweist und der zweite Bearbeitungsanteil (126) eine gebogene Nebenschleiffläche (134) aufweist, wobei der Radius der Hauptschleiffläche (132) größer ist als der Radius der Nebenschleiffläche (134), bevorzugt ist der Radius der Hauptschleiffläche (132) mindestens doppelt so groß, wie der Radius der Nebenschleiffläche (134)
oder
der erste Bearbeitungsanteil (124) eine gerade Hauptschleiffläche (132) aufweist und der zweite Bearbeitungsanteil (126) eine gerade Nebenschleiffläche (134) aufweist, wobei mittels der Hauptschleiffläche (132) mehr Material als mit der Nebenschleiffläche (134) von dem Spendersubstrat (12) entfernt wird
oder
der erste Bearbeitungsanteil (124) eine gerade Hauptschleiffläche (132) aufweist und der zweite Bearbeitungsanteil (126) eine gebogene Nebenschleiffläche (134) aufweist
oder
der erste Bearbeitungsanteil (124) eine gebogene Hauptschleiffläche (132) aufweist und der zweite Bearbeitungsanteil (126) eine gerade Nebenschleiffläche (134) aufweist
oder
die Ablations-LASER-Strahlen (18) mit einer Wellenlänge im Bereich zwischen 300 nm und 10 µm, mit einer Pulsdauer von weniger als 100 Mikrosekunden und bevorzugt von weniger als 1 Mikrosekunde und besonders bevorzugt von weniger als 1/10 Mikrosekunde und mit einer Pulsenergie von mehr als 1µJ und bevorzugt von mehr als 10 µJ erzeugt werden
oder
das im gesamten Bereich zwischen dem Ablösebereich und der zum Ablösebereich homogen beabstandeten Oberfläche abzutragende Material eine ringförmige, insbesondere zylinderförmige, Gestalt beschreibt
oder
wobei die LASER-Strahlen (112) von einer LASER-Einrichtung (146) emittiert werden,
wobei die LASER-Einrichtung (146) ein Picosekundenlaser oder ein Femtosekundenlaser ist
oder
die Energie der LASER-Strahlen (112), insbesondere des fs-LASER, derart gewählt wird, dass die Schädigungsausbreitung einer jeden Modifikation (110) in dem Spendersubstrat (12) kleiner als 3 mal die Rayleighlänge, bevorzugt kleiner als die Rayleighlänge und besonders bevorzugt kleiner ein Drittel mal die Rayleighlänge ist
oder
die Wellenlänge der LASER-Strahlen (112), insbesondere des fs-LASER, derart gewählt wird, dass die Absorption des Spendersubstrats (12) kleiner als 10cm⁻¹ und bevorzugt kleiner als 1cm⁻¹ und besonders bevorzugt kleiner als 0,1cm⁻¹ ist
oder
sich die einzelnen Modifikationen (110) jeweils in Folge einer von den LASER-Strahlen (112), insbesondere des fs-LASER, bewirkten multi-photonen Anregung ergeben
oder
die LASER-Strahlen (112) zum Erzeugen der Modifikationen (110) über eine Oberfläche (116) in den Spenderwafer (12) eindringen, die Bestandteil der abzutrennenden Festkörperscheibe (11) ist
oder
die Spannungserzeugungsschicht (114) ein Polymer, insbesondere Polydimethylsiloxan (PDMS), aufweist oder daraus besteht, wobei die thermische Beaufschlagung derart erfolgt, dass das Polymer einen Glasübergang erfährt, wobei die Spannungserzeugungsschicht (114), insbesondere mittels flüssigem Stickstoff, auf eine Temperatur unterhalb der Raumtemperatur oder unterhalb von 0°C oder unterhalb von -50°C oder unterhalb von -100°C oder unterhalb von -110°C, insbesondere auf eine Temperatur unterhalb der Glasübergangstemperatur der Spannungserzeugungsschicht (114), temperiert wird
oder
die Ablations-Strahlung beschleunigte Ionen und/oder Plasma und/oder LASER-Strahlen umfasst und/oder durch Elektronenstrahlheizen oder Ultraschallwellen gebildet wird und/oder Bestandteil eines lithografischen Verfahrens (Elektronenstrahl, UV, Ionen, Plasma) mit mindestens einem Ätzschritt nach zuvor erfolgter Fotolackbeschichtung ist und/oder das Ablations-Fluid ein Flüssigkeitsstrahl, insbesondere ein Wasserstrahl eines Wasserstrahlschneidprozesses, ist.

10. Verfahren nach einem der vorangegangenen Ansprüche,
**dadurch gekennzeichnet, dass**
der LASER-Strahl (212) oder die LASER-Strahlen derart gegenüber der ebenen Oberfläche (216) des Spendersubstrats (22) geneigt ist, dass er in einem Winkel von ungleich 0° oder 180° gegenüber der Längsachse des Spendersubstrates in das Spendersubstrat eindringt, wobei der LASER-Strahl (212) zum Erzeugen der Modifikation (210) im Spendersubstrat (22) fokussiert wird,
wobei bevorzugt ein erster Anteil (236) des LASER-Strahls (212) in einem ersten Winkel (238) zur ebenen Oberfläche (216) des Spendersubstrats (22) in das Spendersubstrat (22) eindringt und mindestens ein weiterer Anteil (240) des LASER-Strahls (212) in einem zweiten Winkel (242) zur eben Oberfläche (216) des Spendersubstrats (22) in das Spendersubstrat (22) eindringt, wobei sich der Betrag des ersten Winkels (238) von dem Betrag des zweiten Winkels (242) unterscheidet, wobei der erste Anteil (236) des LASER-Strahls (212) und der weitere Anteil (240) des LASER-Strahls (212) zum Erzeugen der Modifikation (210) im Spendersubstrat (22) fokussiert werden.

11. Verfahren nach Anspruch 10,
**dadurch gekennzeichnet, dass**
die Gesamtheit der LASER-Strahlen (212) für die Erzeugung von Modifikationen (210) im Bereich des Zentrums (Z) des Spendersubstrats (22) und für die Erzeugung von Modifikationen (210) im Bereich eines sich in radialer Richtung ergebenden Rands (244), insbesondere in einem Abstand von weniger als 10 mm und bevorzugt von weniger als 5 mm und besonders bevorzugt von weniger als 1 mm zum Rand, des Spendersubstrats (22) in derselben Ausrichtung gegenüber der ebenen Oberfläche (216) des Spendersubstrats (22) ausgerichtet ist
oder
der erste Anteil (236) der LASER-Strahlen (212) in einem ersten Winkel (238) zur ebenen Oberfläche (216) des Spendersubstrats (22) in das Spendersubstrat (22) eindringt und der weitere Anteil (240) der LASER-Strahlen (212) in einem zweiten Winkel (242) für die Erzeugung von Modifikationen (210) im Bereich des Zentrums (Z) des Spendersubstrats (22) und für die Erzeugung von Modifikationen (210) im Bereich eines sich in radialer Richtung ergebenden Rands (244) des Spendersubstrats (22) eindringt, wobei sich der Betrag des ersten Winkels (238) von dem Betrag des zweiten Winkels (242) stets unterscheidet
oder
wobei die LASER-Strahlen (212) von einer LASER-Einrichtung (246) emittiert werden,
wobei die LASER-Einrichtung (246) ein Picosekundenlaser oder ein Femtosekundenlaser ist
oder
die Energie der LASER-Strahlen (212), insbesondere des fs-LASER, derart gewählt wird, dass die Schädigungsausbreitung einer jeden Modifikation (210) in dem Spendersubstrat (22) kleiner als 3 mal die Rayleighlänge, bevorzugt kleiner als die Rayleighlänge und besonders bevorzugt kleiner ein Drittel mal die Rayleighlänge ist
oder
die Wellenlänge der LASER-Strahlen (212), insbesondere des fs-LASER, derart gewählt wird, dass die Absorption des Spendersubstrats (22) kleiner als 10cm⁻¹ und bevorzugt kleiner als 1cm⁻¹ und besonders bevorzugt kleiner als 0,1cm⁻¹ ist
oder
sich die einzelnen Modifikationen (210) jeweils in Folge einer von den LASER-Strahlen (212), insbesondere des fs-LASER, bewirkten multi-photonen Anregung ergeben
oder
die LASER-Strahlen (212) zum Erzeugen der Modifikationen (210) über eine Oberfläche (216) in den Spenderwafer (22) eindringen, die Bestandteil der abzutrennenden Festkörperscheibe (21) ist
oder
der LASER-Strahl (212) über eine umlaufende Oberfläche des Spendersubstrats (22), insbesondere in radialer Richtung des Spendersubstrats (22), in das Spendersubstrat (22) eindringt
und/oder
die über die umlaufende Oberfläche in das Spendersubstrat (22) eingeleiteten LASER-Strahlen (212) Modifikationen (210) erzeugen, die länglich, insbesondere filamentartig, ausgebildet sind,
oder
die an einer Position der umlaufenden Oberfläche des Spendersubstrats (22) eingeleiteten LASER-Strahlen (212) zur Erzeugung mehrerer Modifikationen (210) auf unterschiedliche Eindringtiefen fokussiert wird, wobei die Modifikationen (210) dabei bevorzugt ausgehend von der tiefsten Tiefe hin zur geringsten Tiefe erzeugt werden
oder
ein Mittel zur Aberrationsanpassung vorgesehen ist und durch das Mittel eine Aberrationsanpassung bei den über die umlaufende Oberfläche eindringenden LASER-Strahlen bewirkt wird.

12. Verfahren nach einem der vorangegangenen Ansprüche,
ferner umfassend die Schritte:
Anordnen oder Erzeugen einer Spannungserzeugungsschicht (210) an mindestens einer freiliegenden Oberfläche (212) der Mehrschichtanordnung (28),
Thermisches Beaufschlagen der Spannungserzeugungsschicht (210) zum Erzeugen der mechanischen Spannungen innerhalb der Mehrschichtanordnung (28),
wobei die Spannungen in dem durch den Spenderwafer (26) gebildeten Anteil der Mehrschichtanordnung (28) so groß werden, dass sich im Spenderwafer (26) ein Riss entlang des Ablösebereichs (211) ausbildet, durch den der Spenderwafer (26) in den Abtrennteil (214) und den Verbindungsteil (216) gespalten wird, wobei
die Spannungserzeugungsschicht (210) ein Polymer, insbesondere Polydimethylsiloxan (PDMS), aufweist oder daraus besteht, wobei die thermische Beaufschlagung derart erfolgt, dass das Polymer einen Glasübergang erfährt, wobei die Spannungserzeugungsschicht (210), insbesondere mittels flüssigem Stickstoff, auf eine Temperatur unterhalb der Raumtemperatur oder unterhalb von 0°C oder unterhalb von -50°C oder unterhalb von - 100°C oder unterhalb von -110°C, insbesondere auf eine Temperatur unterhalb der Glasübergangstemperatur der Spannungserzeugungsschicht (210), temperiert wird.

13. Verwendung eines Substrats als Spenderwafer (6) und Bondwafer (2) in einem Mehrkomponentenwaferherstellungsverfahren, insbesondere einem MEMS-Waferherstellungsverfahren, wobei das Substrat als Spenderwafer (6) an einen weiteren Bondwafer (2), der eine Oxidationsschicht aufweist, angeordnet wird, wobei der Spenderwafer (6) dicker ist als der weitere Bondwafer (2) wobei Modifikationen (18) im Inneren des Spenderwafers (6) zum Vorgeben eines Ablösebereichs (11) zum Trennen des Spenderwafers (6) in einen Abtrennteil (14) und einen Verbindungsteil (16) mittels mindestens einem LASER-Strahl erzeugt werden, wobei die Erzeugung der Modifikationen (18) vor dem Anordnen des Spenderwafers (6) an dem weiteren Bondwafer (2) erfolgt, und wobei die LASER-Strahlen (20) über eine Oberfläche des Spenderwafers (6) in den Spenderwafer (6) eindringen, wobei diese Oberfläche des Spenderwafers (6) nach dem Teilen des Spenderwafers (6) Bestandteil des Verbindungsteils (16) ist, wobei der Spenderwafer (6) unter Aufspaltung in den Verbindungsteil (16) und den Abtrennteil (14) infolge einer Rissausbreitung geteilt wird, und wobei der Abtrennteil (14) nach einer Behandlung in einem SiOx-Prozess als Bondwafer (2) dient, wobei der Bondwafer (2) zum Ausbilden einer Mehrschichtanordnung (8) mit einem weiteren Spendersubstrat verbunden wird.

## Claims

1. Method for producing a multi-component wafer (1), especially a MEMS wafer, at least comprising the steps of:
providing a bond wafer (2), where at least a surface portion (4) of the bond wafer (2) is formed by an oxide layer,
providing a donor wafer (6), where the donor wafer (6) is thicker than the bond wafer (2),
contacting the donor wafer (6) with the surface portion (4) of the bond water (2) that is formed by the oxide layer,
forming a multi-layer arrangement (8) by joining the donor wafer (6) and the bond wafer (2) in the region of the contact,
generating modifications (18) in the interior of the donor wafer (6) for mandating a detachment region (11) for separating the donor wafer (6) into a removal part (14) and a joining part (16) by means of at least one LASER beam,
where the modifications (18) are generated before the multi-layer arrangement (8) is formed,
and
where the LASER beams (20) penetrate the donor wafer (6) via a surface of the donor wafer (6), where this surface of the donor wafer (6) is part of the joining part (16) after the dividing of the donor wafer (6), separating the multi-layer arrangement along the detachment region
as a result of a weakening of the multi-layer arrangement brought about by the generation of a sufficient number of modifications, or
as a result of a generation of mechanical stresses in the multi-layer arrangement,
where the joining part (16) remains on the bond wafer (2) and
where the removal part (14) split off has a greater thickness than the joining part (16),
further comprising the steps of:
converting the removal part (14) into a further bond wafer (3) by treatment of at least one surface portion of the removal part (14), and
providing the further bond wafer (3) for contacting with a further donor wafer.

2. Method according to Claim 1,
**characterized in that**
the treatment comprises an oxidation process, more particularly an SiOx process, whereby the at least one surface portion is oxidized.

3. Method according to either of the preceding claims,
**characterized in that**
the donor wafer (6) has a first thickness D1,
the bond wafer (1) has a second thickness D2,
the removal part (14) has a third thickness D3, and
the joining part (16) has a fourth thickness D4,
where the thickness D1 is greater than the sum total of the thicknesses D3 and D4,
where the sum total of the thicknesses D3 and D4 is greater than the thickness D3,
where the thickness D3 is greater by a thickness DL than the thickness D2.

4. Method according to Claim 3,
**characterized in that**
the thickness DL is less than 200 µm, more particularly less than 100 µm, and is removed as a result of polishing and/or etching steps.

5. Method according to any of the preceding claims,
**characterized in that**
the LASER beams (20) are emitted by a LASER device (22), where the LASER device (22) is preferably a picosecond LASER or a femtosecond LASER,
or
where the modifications (18) are local cracks in the crystal lattice and/or portions of material in the interior of the donor wafer (6) that are converted into a different phase.

6. Method according to Claim 5,
**characterized in that**
the energy of the LASER beams (20) of the fs LASER is selected such that the damage propagation of each modification (18) in the donor substrate is less than 3 times the Rayleigh length, preferably less than the Rayleigh length and more preferably less than one third times the Rayleigh length,
and/or
the wavelength of the LASER beams (20) of the fs LASER is selected such that the absorption of the donor substrate (6) is less than 10 cm⁻¹ and preferably less than 1 cm⁻¹ and more preferably less than 0.1 cm⁻¹,
and/or
the individual modifications (18) arise in each case on account of a multi-photon excitation produced by the fs LASER.

7. Method according to Claim 5 or Claim 6,
**characterized in that**
the LASER beams (20) for generating the modifications (18) penetrate the donor wafer (6) via a surface which is part of the joining part (16).

8. Method according to any of the preceding claims,
further comprising the step of:
removing material of the multi-layer arrangement, starting from a surface (14) extending in the circumferential direction of the multi-layer arrangement, and in the direction of the centre (Z) of the multi-layer arrangement, especially for generating a circumferential depression (16),
where the detachment region is exposed by the removal of material,
removing the solid-state layer from the multi-layer arrangement,
where the multi-layer arrangement is weakened by the modifications, in the detachment region, in such a way that the solid-state layer (11) detaches from the multi-layer arrangement as a result of the removal of material,
or
after the removal of material, a number of modifications is generated that is such that the donor substrate is weakened in the detachment region in such a way that the solid-state layer (11) detaches from the donor substrate (12), or
a stress-inducing layer (114) is generated or disposed on a surface (116), more particularly a planar surface (116) of the donor substrate (12), said surface (116) being oriented with an inclination to the circumferential surface, and mechanical stresses are generated in the donor substrate (12) by thermal exposure of the stress-inducing layer (114), where the mechanical stresses give rise to a crack (120) for separating a solid-state layer (11), said crack propagating along the modifications (110), starting from the surface of the donor substrate that is exposed as a result of the removal of material.

9. Method according to Claim 8,
**characterized in that**
the detachment region mandated by the modifications (110) is spaced further apart from the circumferential surface of the donor substrate (12) before the removal of material than after the removal of material
or
the modifications (110) for mandating the detachment region are generated before the removal of material, and the removal of material, at least in places, achieves a reduction in the spacing of the detachment region to less than 10 mm, more particularly to less than 5 mm and preferably to less than 1 mm, or
the modifications for mandating the detachment region are generated after the removal of material, where the modifications (110) are generated in such a way that the detachment region at least in places is at a distance of less than 10 mm, more particularly less than 5 mm and preferably less than 1 mm from a surface exposed by the removal of material,
or
the material is removed by means of ablation beams (8), especial ablation LASER beams, or ablation fluids
or
the removal of material generates a depression (6) having an asymmetric design,
or
the removal of material takes place as a reduction in the radial extent of the donor substrate (12), at least in sections, in the circumferential direction of the donor substrate (12), in the entire region between the detachment region and a surface of the donor substrate (12) that is at a uniform distance from the detachment region,
or
the depression (16) surrounds the donor substrate (12) completely in the circumferential direction
or
the depression (16) runs taperingly, especially in wedge shape, in the direction of the centre (Z) up to a depression end (118), where the depression end (118) is located in the plane in which the crack (120) propagates,
or
the asymmetric depression (16) is generated by a grinding tool (122) shaped negatively, at least in sections, relative to the depression (16),
or
the grinding tool (122) has at least two differently shaped processing portions (124, 126), where a first processing portion (124) is intended for processing the donor substrate (12) in the region of the underside (128) of a solid-state wafer (11) to be removed, and a second processing portion (126) is intended for processing the donor substrate (12) in the region of the top side (130) of the solid-state wafer (11) to be removed from the donor substrate (12),
or
the first processing portion (124) generates a deeper or volumetrically larger depression (16) in the donor substrate (12) than the second processing portion (126), where the first processing portion (124) and/or the second processing portion (126) have curved or straight grinding faces (132, 134),
or
the first processing portion (124) has a curved main grinding face (132), and the second processing portion (126) has a curved secondary grinding face (134), where the radius of the main grinding face (132) is greater than the radius of the secondary grinding face (134), the radius of the main grinding face (132) preferably being at least twice as great as the radius of the secondary grinding face (134),
or
the first processing portion (124) has a straight main grinding face (132), and the second processing portion (126) has a straight secondary grinding face (134), where the main grinding face (132) removes more material from the donor substrate (12) than the secondary grinding face (134),
or
the first processing portion (124) has a straight main grinding face (132), and the second processing portion (126) has a curved secondary grinding face (134),
or
the first processing portion (124) has a curved main grinding face (132), and the second processing portion (126) has a straight secondary grinding face (134),
or
the ablation LASER beams (18) are generated with a wavelength in the range between 300 nm and 10 µm, with a pulse duration of less than 100 microseconds and preferably of less than 1 microsecond and more preferably of less than 1/10 microsecond, and with a pulse energy of more than 1 µJ and preferably of more than 10 µJ,
or
the material to be removed in the entire region between the detachment region and the surface at a uniform distance from the detachment region describes a ringshaped, more particularly cylindrical, design,
or
where the LASER beams (112) are emitted by a LASER device (146),
where the LASER device (146) is a picosecond LASER or a femtosecond LASER
or
the energy of the LASER beams (112), especially of the fs LASER, is selected such that the damage propagation of each modification (110) in the donor substrate (12) is less than 3 times the Rayleigh length, preferably less than the Rayleigh length and more preferably less than one third times the Rayleigh length,
or
the wavelength of the LASER beams (112), especially of the fs LASER, is selected such that the absorption of the donor substrate (12) is less than 10 cm⁻¹ and preferably less than 1 cm⁻¹ and more preferably less than 0.1 cm⁻¹,
or
the individual modifications (110) each arise as a result of a multi-photon excitation brought about by the LASER beams (112), especially of the fs LASER,
or
the LASER beams (112) for generating the modifications (110) penetrate into the donor wafer (12) via a surface (116) which is part of the solid-state wafer (11) to be removed,
or
the stress-inducing layer (114) comprises or consists of a polymer, more particularly polydimethylsiloxane (PDMS), where the thermal exposure takes place such that the polymer experiences a glass transition, where the stress-inducing layer (114) is conditioned, in particular by means of liquid nitrogen, to a temperature below the room temperature or below 0°C or below -50°C or below -100°C or below -110°C, more particularly to a temperature below the glass transition temperature of the stress-inducing layer (114),
or
the ablation radiation comprises accelerated ions and/or plasma and/or LASER beams and/or is formed by electron beam heating or ultrasound waves and/or is part of a lithographic process (electron beam, UV, ion, plasma) with at least one etching step after prior photoresist coating and/or the ablation fluid is a liquid jet, more particularly a waterjet of a waterjet cutting process.

10. Method according to any of the preceding claims,
**characterized in that**
the LASER beam (212) or the LASER beams is or are inclined relative to the planar surface (216) of the donor substrate (22) in such a way that the beam penetrates into the donor substrate at an angle not equal to 0° or 180° relative to the longitudinal axis of the donor substrate, where the LASER beam (212) is focused for generating the modification (210) in the donor substate (22),
where preferably a first portion (236) of the LASER beam (212) penetrates into the donor substrate (22) at a first angle (238) to the planar surface (216) of the donor substrate (22), and at least one further portion (240) of the LASER beam (212) penetrates into the donor substrate (22) at a second angle (242) to the planar surface (216) of the donor substrate (22), where the absolute value of the first angle (238) differs from the absolute value of the second angle (242), where the first portion (236) of the LASER beam (212) and the further portion (240) of the LASER beam (212) are focused for generating the modification (210) in the donor substrate (22).

11. Method according to Claim 10,
**characterized in that**
the totality of the LASER beams (212) for generating modifications (210) in the region of the centre (Z) of the donor substrate (22) and for generating modifications (210) in the region of an edge (244) arising in a radial direction, more particularly at a distance of less than 10 mm and preferably of less than 5 mm and more preferably of less than 1 mm from the edge, of the donor substrate (22) are aligned in the same orientation relative to the planar surface (216) of the donor substrate (22),
or
the first portion (236) of the LASER beams (212) penetrates into the donor substrate (22) at a first angle (238) with respect to the planar surface (216) of the donor substrate (22), and the further portion (240) of the LASER beams (212) penetrates at a second angle (242) for generating modifications (210) in the region of the centre (Z) of the donor substrate (22) and for generating modifications (210) in the region of an edge (244) of the donor substrate (22) that arises in a radial direction, where the absolute value of the first angle (238) always differs from the absolute value of the second angle (242),
or
where the LASER beams (212) are emitted by a LASER device (246),
where the LASER device (246) is a picosecond LASER or a femtosecond LASER,
or
the energy of the LASER beams (212), especially of the fs LASER, is selected such that the damage propagation of each modification (210) in the donor substrate (22) is less than 3 times the Rayleigh length, preferably less than the Rayleigh length and more preferably less than one third times the Rayleigh length,
or
the wavelength of the LASER beams (212), especially of the fs LASER, is selected such that the absorption of the donor substrate (22) is less than 10 cm⁻¹ and preferably less than 1 cm⁻¹ and more preferably less than 0.1 cm⁻¹,
or
the individual modifications (210) each arise as a result of a multi-photon excitation produced by the LASER beams (212), especially of the fs LASER,
or
the LASER beams (212) for generating the modifications (210) penetrate into the donor wafer (22) via a surface (216) which is part of the solid-state wafer (21) to be removed,
or
the LASER beam (212) penetrates into the donor substrate (22) via a circumferential surface of the donor substate (22), especially in a radial direction of the donor substrate (22),
and/or
the LASER beams (212) introduced into the donor substrate (22) via the circumferential surface generate modifications (210) which are elongate, more particularly filament-like, in form,
or
the LASER beams (212) introduced at a position of the circumferential surface of the donor substrate (22) are focused to different penetration depths for generating a plurality of modifications (210), where the modifications (210) are in this case preferably generated starting from the deepest depth towards the smallest depth,
or
a means for aberration adaptation is provided, and the means brings about an aberration adaptation in the case of the LASER beams penetrating via the circumferential surface.

12. Method according to any of preceding claims,
further comprising the steps of:
disposing or generating a stress-inducing layer (210) on at least one exposed surface (212) of the multi-layer arrangement (28),
thermally exposing the stress-inducing layer (210) for generating mechanical stresses within the multi-layer arrangement (28),
where the stresses in the portion of the multi-layer arrangement (28) that is formed by the donor wafer (26) becomes so great that a crack forms in the donor wafer (26) along the detachment region (211) and splits the donor wafer (26) into the removal part (214) and the joining part (216), where
the stress-inducing layer (210) comprises or consists of a polymer, more particularly polydimethylsiloxane (PDMS), where the thermal exposure is such that the polymer undergoes a glass transition, where the stress-inducing layer (210) is conditioned, in particular by means of liquid nitrogen, to a temperature below the room temperature or below 0°C or below -50°C or
below -100°C or below -110°C, more particularly to a temperature below the glass transition temperature of the stress-inducing layer (210).

13. Use of a substrate as donor wafer (6) and bond wafer (2) in a multi-component wafer production process, more particularly a MEMS wafer production process,
where the substrate as donor wafer (6) is disposed on a further bond wafer (2) which has an oxidation layer,
where the donor wafer (6) is thicker than the further bond wafer (2),
where modifications (18) are generated in the interior of the donor wafer (6) for mandating a detachment region (11) for separating the donor wafer (6) into a removal part (14) and a joining part (16), by means of at least one LASER beam,
where the modifications (18) are generated before the donor wafer (6) is disposed on the further bond wafer (2),
and
where the LASER beams (20) penetrate into the donor wafer (6) via a surface of the donor wafer (6), where this surface of the donor wafer (6) is part of the joining part (16) after the dividing of the donor wafer (6),
where the donor wafer (6) is divided, with splitting, into the joining part (16) and the removal part (14) as a result of a crack propagation, and
where the removal part (14) serves as bond wafer (2) after a treatment in an SiOx process,
where the bond wafer (2) is joined to a further donor substrate to form a multi-layer arrangement (8).

## Revendications

1. Procédé de fabrication d'une tranche (1) à plusieurs constituants, notamment d'une tranche MEMS, comprenant au moins les stades :
on se procure une tranche (2) de bond, au moins une partie de la surface de la tranche (2) de bond étant constituée d'une couche d'oxyde,
on se procure une tranche (6) de donneur, la tranche (6) de donneur étant plus épaisse que la tranche (2) de bond,
on met la tranche (6) de donneur en contact avec la partie de surface formée de la couche d'oxyde de la tranche (2) de bond,
on forme un agencement (8) à plusieurs couches par liaison de la tranche (6) de donneur et de la tranche (2) de bond dans la région du contact,
on produit des modifications (18) au sein de la tranche (6) de donneur pour prescrire une région (11) de détachement pour séparer la tranche (6) de donneur en une partie (14) de séparation et une partie (16) de liaison au moyen d'au moins un faisceau LASER,
dans lequel la production des modifications (18) a lieu avant la formation de l'agencement (8) de plusieurs couches,
et
dans lequel le faisceau (20) LASER pénètre par une surface de la tranche (6) de donneur dans la tranche (6)de donneur, cette surface de la tranche (6) de donneur étant, après la séparation de la couche (6) de donneur, une partie constitutive de la partie (16) de liaison,
on sépare l'agencement de plusieurs couches le long de la région de détachement
en raison d'un affaiblissement, provoqué par la production d'un nombre suffisant de modifications, de l'agencement de plusieurs couches ou en raison d'une production de contraintes mécaniques dans l'agencement de plusieurs couches,
dans lequel la partie (16) de liaison reste sur la tranche (2) de bond et dans lequel la partie (14) de séparation séparée a une épaisseur plus grande que la partie (16) de liaison,
comprenant, en outre, les stades :
on transforme la partie (14) de séparation, par un traitement au moins d'une partie de surface de la partie (14) de séparation, en une autre tranche (3) de bond et
on met à disposition l'autre tranche (3) de bond pour la mise en contact avec une autre tranche de donneur.

2. Procédé suivant la revendication 1,
**caractérisé en ce que**
le traitement comprend un processus d'oxydation, notamment un processus SiOx, par lequel on provoque une oxydation de la au moins une partie de surface.

3. Procédé suivant l'une des revendications précédentes,
**caractérisé en ce que**
la tranche (6) de donneur a une première épaisseur D1,
la tranche (2) de bond a une deuxième épaisseur D2,
la partie (14) de séparation a une troisième épaisseur D3, et
la partie (16) de liaison a une quatrième épaisseur D4,
l'épaisseur D1 étant plus grande que la somme des épaisseurs D3 et D4,
la somme des épaisseurs D3 et D4 étant plus grande que l'épaisseur D3,
l'épaisseur D3 est plus grande d'une épaisseur DL que l'épaisseur D2.

4. Procédé suivant la revendication3,
**caractérisé en ce que**
l'épaisseur DL est de moins de 200µm, notamment de moins de 100 µm, et est éliminée en raison de stade de polissage et/ou d'attaque chimique.

5. Procédé suivant l'une des revendications précédentes,
**caractérisé en ce que** l'on émet le faisceau (20) LASER d'un dispositif (22) LASER,
le dispositif (22) LASER étant de préférence un laser à picoseconde ou laser à femtoseconde
ou
dans lequel les modifications (18) sont des fissures locales dans le réseau cristallin et/ou des parties de matériau transformées en une autre phase au sein de la tranche (6) de donneur.

6. Procédé suivant la revendication 5,
**caractérisé en ce que**
l'on choisit l'énergie du faisceau (20) LASER du LASER fs, de manière à ce que la propagation d'endommagement de chaque modification (18) dans le substrat de donneur soit plus petite que 3 fois la longueur de Rayleigh, de préférence plus petite que la longueur de Rayleigh et, d'une manière particulièrement préférée, plus petite qu'un tiers de la longueur de Rayleigh
et/ou
on choisit la longueur d'onde du faisceau (20) LASER du LASER fs de manière à ce que l'absorption du substrat (6) de donneur soit plus petite que 10cm⁻¹ et, de préférence, plus petite que 1cm⁻¹ et, d'une manière particulièrement préférée, plus petite que 0,1cm⁻¹
et/ou
les diverses modifications (18) proviennent d'une excitation par de multiples photons provoqués par le LASER fs.

7. Procédé suivant la revendication 5 ou la revendication 6,
**caractérisé en ce que**
le faisceau (20) LASER pénètre, pour la production des modifications (18), dans la tranche (6) de donneur par une surface, qui est une partie constitutive de la partie (16) de liaison.

8. Procédé suivant l'une des revendications précédentes,
comprenant, en outre le stade :
on enlève du matériau de l'agencement de plusieurs couches, à partir d'une surface (14),
s'étendant dans la direction de pourtour de l'agencement de couches multiples, en direction du centre (Z) de l'agencement de couches multiples, pour produire notamment un creux (16) faisant le tour,
dans lequel, par l'enlèvement de matériau, on dégage une région de détachement,
on sépare la couche de semi-conducteur de l'agencement de plusieurs couches,
dans lequel on affaiblit l'agencement de plusieurs couches dans la région de détachement par les modifications, de manière à ce que la couche (11) de semi-conducteur se détache en raison de l'enlèvement de matériau de l'agencement de couches multiples
ou
après l'enlèvement de matériau, on produit un nombre de modifications tel que le substrat de donneur est affaibli dans la région de détachement, de façon à ce que la couche (11) de semi-conducteur se détache du substrat (2) de donneur ou
on produit ou on met une couche (114) de production de contraintes sur une surface (116), dirigée de manière inclinée par rapport à la surface faisant le tour, notamment plane, du substrat (12) de donneur et on produit, par un traitement thermique de la couche (114) de production de contraintes, des contraintes mécaniques dans le substrat (12) de donneur, dans lequel il se crée, par les contraintes mécaniques, une fissure (120) de séparation d'une couche (11) de semi-conducteur, qui, à partir de la surface mise à nu par l'enlèvement de matériau du substrat de donneur, se propage le long des modifications (110).

9. Procédé suivant la revendication 8,
**caractérisé en ce que**
la région de détachement prescrite par les modifications (110) avant l'enlèvement de matériau est à une distance plus grande de la surface faisant le tour du substrat (12) de donneur qu'après l'enlèvement de matériau
ou
on produit les modifications (110) pour prescrire la région de détachement avant l'enlèvement de matériau et, par l'enlèvement de matériau, on obtient, au moins par endroits, une réduction de la distance de la région de détachement à moins de 10mm, notamment à moins de 5mm et de préférence à moins de 1mm ou
on produit les modifications pour prescrire la région de détachement après l'enlèvement de matériau, les modifications (110) étant produites de manière à ce que la région de détachement soit, au moins par endroit, à une distance de moins de 10mm, notamment de moins de 5mm et de préférence de moins de 1mm, d'une surface mise à découvert par l'enlèvement de matériau
ou
on élimine le matériau au moyen d'un faisceau (8) d'ablation, notamment d'un faisceau LASER d'ablation ou de fluides d'ablation
ou
on produit l'enlèvement par l'enlèvement de matériau un creux (6) de forme dissymétrique,
ou
l'enlèvement de matériau a lieu, au moins par endroits, dans la direction du pourtour du substrat (12) de donneur dans l'ensemble de la région, entre la région de détachement et une surface à distance de manière homogène de la région de détachement, du substrat (12) de donneur sous la forme d'une réduction de l'étendue radiale du substrat (12) donneur
ou
le creux (16) entoure le substrat (12) de donneur complètement dans la direction du pourtour
ou
le creux (16) s'étend en devenant plus étroit, notamment en étant cunéiforme en direction du centre (Z) jusqu'à une extrémité (118) du creux, l'extrémité (118) du creux étant dans un plan, dans lequel la fissure (120) se propage
ou
on produit le creux (16) dissymétrique au moyen d'un outil (122) de meulage conformé de manière négative, au moins par endroits, par rapport au creux (16)
ou
l'outil (122) de meulage a au moins deux parties (124, 126) d'usinage conformées de manière différente, une première partie (124) d'usinage étant destinée à usiner le substrat (12) de donneur dans la région du côté (118) inférieur d'un disque (11) de semi-conducteur à séparer et une deuxième partie (126) d'usinage étant destinée à usiner le substrat (12) de donneur dans la région du côté (130) supérieur du disque (11) de semi-conducteur à séparer du substrat (12) de donneur
ou
la première partie (124) d'usinage produit un creux (16) plus profond ou plus grand en volume dans le substrat (12) de donneur que la deuxième partie (126) d'usinage, la première partie (124) d'usinage et/ou la deuxième partie (126) d'usinage ayant des surfaces (132, 134) de meulage incurvées ou droites
ou
la première partie (124) d'usinage a une surface (132) de meulage principale incurvée et la deuxième partie (126) d'usinage a une surface (134) de meulage auxiliaire incurvée, le rayon de la surface (132) de meulage principale étant plus grand que le rayon de la surface (134) de meulage auxiliaire, le rayon de la surface (132) de meulage principale étant de préférence au moins deux fois plus grand que le rayon de la surface (134) de meulage auxiliaire
ou
la première partie (124) d'usinage a une surface (132) de meulage principale droite et la deuxième partie (126) d'usinage a une surface (134) de meulage auxiliaire droite, dans lequel, au moyen de la surface (132) d'usinage principale, on élimine du substrat (12) de donneur plus de matériau qu'avec la surface (134) de meulage auxiliaire
ou
la première partie (124) d'usinage a une surface (132) de meulage principale droite et la deuxième partie (126) d'usinage a une surface (134) d'usinage auxiliaire incurvée
ou
la première partie (124) d'usinage a une surface (132) d'usinage principale incurvée et la deuxième partie (126) d'usinage a une surface (134) de meulage auxiliaire
ou
on produit le faisceau (18) LASER d'ablation à une longueur d'onde dans le domaine compris entre 300 nm et 10 µm, en ayant une durée d'impulsion de moins de 100 microsecondes et de préférence de moins de 1 microseconde et d'une manière particulièrement préférée de moins de 1/10^{ème} de microseconde et en ayant une énergie d'impulsion de plus de 1µJ et de préférence de plus de 10 µJ
ou
le matériau à enlever entre la région de détachement et la surface à distance de manière homogène de la région de détachement décrit une forme annulaire, notamment une forme cylindrique
ou
on émet les faisceaux (112) LASER par un dispositif (146) LASER, le dispositif (146) LASER étant un laser à picoseconde ou un laser à femtoseconde
ou
l'on choisit l'énergie du faisceau (20) LASER du LASER fs, de manière à ce que la propagation d'endommagement de chaque modification (18) dans le substrat de donneur soit plus petite que 3 fois la longueur de Rayleigh, de préférence plus petite que la longueur de Rayleigh et, d'une manière particulièrement préférée, plus petite qu'un tiers de la longueur de Rayleigh
ou
on choisit la longueur d'onde du faisceau (112) LASER du LASER fs de manière à ce que l'absorption du substrat (12) de donneur soit plus petite que 10cm⁻¹ et de préférence plus petite que 1cm⁻¹ et, d'une manière particulièrement préférée, plus petite que 0,1cm⁻¹
ou
les diverses modifications (110) proviennent chacune d'une excitation par de multiples photons provoqués par les faisceaux (112) LASER, en particulier les LASER fs.
ou
les faisceaux (112) LASER pénètrent, pour la production des modifications (110) par une surface (116) dans la tranche (12) de donneur, qui est une partie constitutive du disque (11) de semi-conducteur à séparer
ou
la couche (114) de production de contraintes a un polymère, notamment du polydiméthylsiloxane (PDMS) ou en est constitué, le traitement thermique s'effectue de manière à ce que le polymère subisse une transition à l'état vitreux, la couche (114) de production de contraintes étant mise en température, notamment au moyen d'azote liquide, jusqu'à une température inférieure à la température ambiante ou inférieure à 0°C ou inférieure à -50°C ou inférieure à -100°C ou inférieur à -110°C, notamment jusqu'à une température inférieure au point de transition à l'état vitreux de la couche (114) de production de contraintes
ou
le rayonnement d'ablation comprend des ions accélérés et/ou un plasma et/ou un faisceau LASER et/ou est formé par chauffage d'un faisceau d'électrons ou par des ondes ultrasonores et/ou fait partie d'un procédé lithographique (faisceau d'électrons, UV, ions, plasma) ayant au moins un stade d'attaque chimique après avoir effectué au préalable un revêtement par un vernis photosensible et/ou le fluide d'ablation est un jet de liquide, notamment un jet d'eau d'un processus de découpe par jet d'eau.

10. Procédé suivant l'une des revendications précédentes,
**caractérisé en ce que**
le faisceau (212) LASER ou les faisceaux LASER est incliné par rapport à la surface (216) plane du substrat (22) de donneur, de manière à pénétrer dans le substrat de donneur suivant un angle différent de 0° ou de 180° avec l'axe longitudinal du substrat de donneur, le faisceau (212) LASER étant focalisé pour obtenir la modification (210) dans le substrat (22) de donneur,
dans lequel, de préférence, une première partie (236) du faisceau (212) LASER pénètre dans le substrat (22) de donneur suivant un premier angle (238) par rapport à la surface (216) plane du substrat (22) de donneur et au moins une autre partie (240) du faisceau (212) LASER pénètre dans le substrat (22) de donneur suivant un deuxième angle (242) par rapport à la surface (216) plane du substrat (22) de donneur, la valeur absolue du premier angle (238) étant différente de la valeur du deuxième angle (242), la première partie (236) du faisceau (212) LASER et l'autre partie (240) du faisceau (212) LASER étant focalisées pour la production de la modification (210) dans le substrat (22) de donneur.

11. Procédé suivant la revendication 10,
**caractérisé en ce que**
la totalité des faisceaux (212) LASER est, pour la production de modifications (210) dans la région du centre (Z) du substrat (22) de donneur et pour la production de modifications (210) dans la région d'un bord (244) s'étendant dans la direction radiale, notamment à une distance de moins de 10 mm et de préférence de moins de 5 mm et d'une manière particulièrement préférée de moins de 1 mm du bord, du substrat (22) de donneur dirigé dans la même orientation par rapport à la surface (216) plane du substrat (22) de donneur
ou
la première partie (236) des faisceaux (212) LASER pénètre dans le substrat (22) de donneur suivant un premier angle (238) par rapport à la surface (216) plane du substrat (22) de donneur et l'autre partie (240) des faisceaux (212) LASER pénètre suivant un deuxième angle (242) pour la production de modifications (210) dans la région du centre (Z) du substrat (22) de donneur et pour la production de modifications (210) dans la région d'un bord (244) s'étendant dans la direction radiale du substrat (22) de donneur, la valeur du premier angle (238) étant toujours différente de la valeur du deuxième angle (242)
ou
dans lequel les faisceaux (212) LASER sont émis par un dispositif (246) LASER,
le dispositif (246) LASER étant un laser à picoseconde ou un laser à femtoseconde
ou
on choisit l'énergie des faisceaux (212) LASER, notamment du LASER fs, de manière à ce que la propagation d'endommagement de chaque modification (210) dans le substrat (22) de donneur soit plus petite que 3 fois la longueur de Rayleigh, de préférence plus petite que la longueur de Rayleigh et d'une manière particulièrement préférée, plus petite qu'un tiers de la longueur de Rayleigh
ou
on choisit la longueur d'onde du faisceau (212) LASER du LASER fs de manière à ce que l'absorption du substrat (22) de donneur soit plus petite que 10cm⁻¹ et de préférence plus petite que 1cm⁻¹ et d'une manière particulièrement préférée plus petite que 0,1cm⁻¹
ou
les diverses modifications (210) proviennent chacune d'une excitation par de multiples photons provoqués par les faisceaux (212) LASER, en particulier du LASER fs.
ou
les faisceaux (212) LASER pénètrent, pour la production des modifications (210) dans la tranche (22) de donneur par une surface (216), qui est une partie constitutive du disque (21) de semi-conducteur à séparer
ou
le faisceau (212) LASER pénètre dans le substrat (22) de donneur, notamment dans la direction radiale du substrat (22) de donneur par une surface faisant le tour du substrat (22) de donneur
et/ou
les faisceaux (212) LASER appliqués par la surface faisant le tour au substrat (22) de donneur produisent des modifications (210), qui sont constituées longitudinalement, en étant notamment de type en filament, ou
on focalise les faisceaux (212) LASER appliqués à une position de la surface faisant le tour du substrat (22) de donneur, pour la production de plusieurs modifications (210), sur des profondeurs de pénétration différentes, les modifications (210) étant produites, de préférence, en partant de la profondeur la plus grande à la profondeur la plus petite
ou
il est prévu un moyen d'adaptation d'aberration et on provoque par le moyen une adaptation d'aberration pour les faisceaux LASER pénétrant par la surface faisant le tour.

12. Procédé suivant l'une des revendications précédentes,
comprenant, en outre, les stades :
on met ou on produit une couche (210) de production de contraintes sur au moins une surface (212) mise à découvert de l'agencement (28) de couches multiples,
on traite thermiquement la couche (210) de production de contrainte pour produire des contraintes mécaniques au sein de l'agencement (28) de couches multiples,
dans lequel les contraintes dans la partie, formée par la tranche (26) de donneur, de l'agencement (28) de couches multiples sont si grandes qu'il se constitue, dans la tranche (26) de donneur, une fissure le long d'une région (211) de détachement, par laquelle la tranche (26) de donneur est séparée en la partie (214) de séparation et en la partie (216) de liaison, dans lequel
la couche (210) de production de tension a un polymère, notamment du polydiméthylsioxane (PDMS) ou en est constituée, le traitement thermique étant effectué de manière à ce que le polymère subisse une transition à l'état vitreux, la couche (210) de production de contraintes étant mise en température, notamment au moyen d'azote liquide, à une température en dessous de la température ambiante ou en dessous de 0°C ou en dessous de -50°C ou en dessous de -100°C ou en dessous de - 110°C, notamment à une température en dessous du point de transition à l'état vitreux de la couche (210) de production de contraintes.

13. Utilisation d'un substrat comme tranche (6) de donneur et tranche (2) de bond dans un procédé de fabrication de tranches à plusieurs constituants, notamment dans un procédé de fabrication de tranches MEMS,
dans laquelle on met le substrat comme tranche (6) de donneur sur une autre tranche (2) de bond, qui a une couche d'oxydation,
dans laquelle la tranche (6) de donneur est plus épaisse que l'autre tranche (2) de bond,
dans laquelle on produit des modifications (18) à l'intérieur de la tranche (6) de donneur pour prescrire une région (11) de détachement pour la séparation de la tranche (6) de donneur, en une partie (14) de séparation et en une partie (16) de liaison, au moyen d'au moins un faisceau LASER,
la production des modifications (18) s'effectuant avant de mettre la tranche (6) de donneur sur l'autre tranche (2) de bond,
et
les faisceaux (20) LASER pénétrant dans la tranche (6) de donneur par une surface de la tranche (6) de donneur, cette surface de la tranche (6) de donneur étant, après la séparation de la tranche (6) de donneur, une partie constitutive de la partie (16) de liaison,
la tranche (6) de donneur étant séparée en raison d'une propagation de fissures avec séparation en la partie (16) de liaison et la partie (14) de séparation, et
la partie (14) de séparation servant de tranche (2) de bond après un traitement dans un processus SiOx,
la tranche (2) de bond étant reliée à un autre substrat de donneur pour constituer un agencement (8) de couches multiples.
